# FASCICULE DE BREVET EUROPEEN

(11) **EP 2 360 838 B1**
(45) Date de publication et mention de la délivrance du brevet: **05.09.2012**
(21) Numéro de dépôt: 11155141.2
(22) Date de dépôt: 21.02.2011
(51) Int. Cl.: H03M 1/12, H03M 1/16

(54) **Procédé de conversion analogique/numérique du type logarithmique d'un signal analogique d'entrée, et dispositif correspondant**
Verfahrem zur logarithmische Analog-Digital-Wandlung eines analogen Eingangssignals und entsprechende Vorrichtung
Method for logarithmic analog-to-digital conversion of an analog input signal and corresponding apparatus

(30) Priorité: 23.02.2010 FR 1051279
(43) Date de publication de la demande: 24.08.2011
(73) Titulaire: STMicroelectronics SA, 92120 Montrouge (FR); Centre National de la Recherche Scientifique (CNRS), 75016 Paris (FR)
(72) Inventeur: Gorisse, Jean, 38000 Grenoble (FR); Cathelin, F. Andreia, 38190 Laval (FR); Kaiser, Andreas, 59650 Villeneuve d'Ascq (FR); Kerherve, Eric, 33400 Talence (FR)
(74) Mandataire: Zapalowicz, Francis

(56) Documents cités:
- US-A- 5 748 133
- US-A1- 2006 250 290
- TAO ZHOU ET AL: "ADC architecture with direct binary output for digital controllers of high-frequency SMPS", CONFERENCE PROCEEDINGS. IPEMC 2006. CES/IEEE 5TH INTERNATIONAL POWER ELECTRONICS AND MOTION CONTROL CONFERENCE 14-16 AUG. 2006 SHANGHAI, CHINA, IEEE, CONFERENCE PROCEEDINGS. IPEMC 2006. CES/IEEE 5TH INTERNATIONAL POWER ELECTRONICS AND MOTION CONTROL, 14 août 2006 (2006-08-14), pages 1-5, XP031421381, DOI: DOI:10.1109/IPEMC.2006.4778098 ISBN: 978-1-4244-0448-3

## Description

L'invention concerne la conversion analogique/numérique d'un signal analogique, et, plus particulièrement, la conversion analogique/numérique du type logarithmique, particulièrement utile lorsque le signal analogique est représentatif d'une quantité physique (électrique, thermique, ...) au travers d'une loi du type exponentiel.

US2006/0250 290 A1 décrit des convertisseurs analogique/numérique, et plus particulièrement des convertisseurs analogique / numérique « flash »

Avec un convertisseur analogique/numérique linéaire, la variation de quantité physique correspondant à une variation d'un bit de poids faible dans le mot numérique de sortie délivré par le convertisseur dépend de la valeur de ce mot numérique.

C'est la raison pour laquelle on utilise de préférence un convertisseur analogique/numérique du type logarithmique dans lequel cette variation d'un bit de poids faible représente la même variation de quantité physique quelle que soit la valeur du mot numérique délivré en sortie du convertisseur.

Il existe de nombreuses structures de convertisseurs analogiques numériques du type logarithmique.

On peut ainsi citer notamment les architectures utilisant un amplificateur opérationnel avec une diode connectée entre la sortie et l'entrée négative de cet amplificateur opérationnel. De tels dispositifs présentent cependant une forte dépendance à la température et une piètre stabilité de boucle qui conduit à une plage dynamique de conversion limitée.

On peut également citer les convertisseurs analogiques/numériques utilisant des architectures pipelinées à capacités commutées. De telles architectures présentent notamment une forte complexité de réalisation et une consommation de courant importante.

On peut également citer l'article de Tao ZHOU et autre intitulé « ADC architecture with direct binary output for digital controllers of high-frequency SMPS », 2006 IEEE, qui décrit un convertisseur analogique / numérique dont la sortie peut être compressée en un caractère d'adressage beaucoup plus petit et de type logarithmique.
On peut encore citer US 5 748 133 qui décrit un convertisseur analogique / numérique opérationnel, dont une application est un convertisseur du type compression considérée comme étant basiquement une fonction logarithmique.

Selon un mode de réalisation, il est proposé notamment une nouvelle architecture de convertisseur analogique/numérique du type logarithmique présentant en particulier une large plage de fonctionnement dynamique et offrant également une flexibilité de réalisation.

Selon un mode de mise en oeuvre et de réalisation, il est également proposé une architecture de convertisseur analogique/numérique du type logarithmique capable de fonctionner sous une faible tension d'alimentation avec une faible consommation de courant et présentant une taille réduite.

Selon un mode de réalisation et de mise en oeuvre, il est proposé une solution basée sur une compression progressive logarithmique avec, optionnellement, l'utilisation d'un convertisseur analogique/numérique linéaire.

Plus précisément, le dispositif amplificateur logarithmique à compression progressive génère, entre chaque amplificateur de compression, une tension qui est linéaire sur une courte zone par rapport à la tension d'entrée du dispositif amplificateur, lorsqu'elle est exprimée dans une échelle logarithmique. En comparant certaines au moins des tensions générées à une référence commune, on obtient un code thermométrique qui indique dans quelle zone est située la tension d'entrée. Le code thermométrique est ensuite converti dans un code binaire pour former les bits de poids fort d'un mot numérique de sortie. Ces bits peuvent être considérés comme des bits « grossiers », car résultant d'une première conversion dite « grossière ».

Lorsqu'une précision plus importante est requise, l'information de code thermométrique peut aussi être utilisée pour sélectionner, à travers un multiplexeur analogique, la zone linéaire de l'une des tensions générées. La tension ainsi sélectionnée est ensuite numérisée à travers un convertisseur analogique/numérique linéaire de façon à générer les bits de résolution plus fine du mot numérique de sortie délivré par le convertisseur. Ces bits peuvent être alors considérés comme des bits « fins », car résultant d'une deuxième conversion dite « fine ».

Ainsi, selon un aspect, il est proposé un procédé de conversion analogique numérique du type logarithmique d'un signal analogique d'entrée, ladite conversion comprenant :
- une amplification logarithmique à compression progressive du signal d'entrée délivrant une séquence de plusieurs signaux analogiques secondaires, l'évolution des valeurs de certains au moins des signaux secondaires en fonction des valeurs du signal analogique d'entrée comportant des zones correspondant à une évolution linéaire desdits signaux secondaires en fonction de celle du signal d'entrée exprimée dans une échelle logarithmique,
- une comparaison de certains au moins des signaux secondaires de ladite séquence avec un signal de référence commun dont la valeur se situe dans chacune desdites zones, fournissant une information de code thermométrique, et
- une élaboration d'un premier mot numérique à partir de l'information de code thermométrique.

De façon à utiliser au maximum ladite zone linéaire de chaque signal secondaire, la valeur du signal de référence est préférentiellement choisie telle que lorsqu'un signal secondaire de rang i dans la séquence prend la valeur égale à la valeur du signal de référence, la valeur correspondante du signal secondaire de rang i-1 se situe dans ladite zone de signal secondaire de rang i-1.

Ainsi, en pratique, on pourra par exemple choisir une valeur de référence se situant au voisinage de la valeur inférieure de chaque zone.

Selon un mode de mise en oeuvre, l'élaboration du premier mot numérique comprend une conversion de l'information de code thermométrique en une information de code intermédiaire, un bit de rang i de l'information de code intermédiaire étant obtenu à partir du produit du complément du bit de rang i et du bit de rang i-1 ou de son complément, de l'information de code thermométrique, et une conversion de l'information de code intermédiaire en une information de code binaire formant ledit premier mot numérique.

Lorsqu'on souhaite améliorer la résolution de la conversion analogique numérique, il est prévu, selon un mode de mise en oeuvre, que le procédé comprenne en outre une sélection de l'un des signaux secondaires de la séquence à partir de l'information de code thermométrique, une conversion analogique/numérique secondaire du signal secondaire sélectionné, une information secondaire de code thermométrique et une conversion de cette information secondaire de code thermométrique en un deuxième mot numérique, les premier et deuxième mots numériques formant respectivement des première et deuxième parties d'un mot numérique de sortie, la deuxième partie ayant un poids plus faible que la première partie.

En d'autres termes, les bits du premier mot numérique forment les bits dits « grossiers » (« coarse bits », en langue anglaise) du mot numérique de sortie, tandis que les bits du deuxième mot numérique forment les bits fins (« fine bits » en langue anglaise) du mot numérique de sortie.

Ladite sélection du signal secondaire est avantageusement effectuée à partir de l'information de code intermédiaire.

Selon un mode de mise en oeuvre, toutes lesdites zones linéaires s'étendent au moins entre une première valeur limite inférieure commune et une première valeur limite supérieure commune, et la conversion analogique/numérique secondaire du signal secondaire sélectionné comprend une comparaison du signal secondaire avec des seuils de référence régulièrement répartis entre ladite première valeur limite inférieure commune et ladite première valeur limite supérieure commune.

Cela étant, la linéarité du convertisseur analogique/numérique dépend de la corrélation entre les bits grossiers et les bits fins, qui est notamment directement impactée par la précision des comparateurs effectuant les comparaisons avec le signal de référence commun.

En d'autres termes, une erreur dans la conversion grossière va induire une erreur sur le segment sélectionné, pouvant conduire à ce que la sortie du multiplexeur analogique, qui effectue la sélection, excède la plage de conversion du convertisseur analogique/numérique secondaire.

Pour remédier à ce problème, il est proposé d'augmenter la plage de conversion du convertisseur analogique/numérique secondaire en ajoutant des seuils de référence supplémentaires.

Il devient alors nécessaire de corréler les bits fins aux bits grossiers pour former un unique code numérique de sortie continu.

En d'autres termes, lorsque certaines applications nécessitent de compenser de telles erreurs éventuelles, il est avantageusement prévu, selon un mode de mise en oeuvre, que la conversion analogique/numérique secondaire du signal secondaire sélectionné comprenne une comparaison du signal secondaire avec des seuils de référence régulièrement répartis entre une deuxième valeur limite inférieure plus faible que ladite première valeur limite inférieure commune, et une deuxième valeur limite supérieure plus élevée que ladite première valeur limite supérieure commune ; ceci revient à rajouter des seuils de comparaison dans la plage de conversion du convertisseur analogique/numérique secondaire.

Le procédé comprend alors en outre un étalonnage de ladite conversion analogique numérique avec un signal analogique d'étalonnage en tant que signal d'entrée ; ce signal d'étalonnage suit une évolution temporelle monotone ;
le procédé comprend alors une élaboration d'une table de correspondance entre les premier et deuxième mots numériques successivement obtenus lors de la conversion analogique/numérique du signal d'étalonnage et des mots numériques de sortie désirés formant ensemble un code numérique binaire continu.

Selon un autre aspect, il est proposé un dispositif de conversion analogique/numérique logarithmique, comportant des moyens d'entrée configurés pour recevoir un signal d'entrée analogique, et des moyens de traitement connectés aux moyens d'entrée.

Selon une caractéristique générale de cet aspect, les moyens de traitement comprennent des moyens d'amplification logarithmique à compression progressive connectés aux moyens d'entrée et comportant
- une chaîne de plusieurs étages amplificateurs configurés pour délivrer chacun un signal analogique secondaire, l'évolution des valeurs de certains au moins des signaux analogiques secondaires en fonction des valeurs du signal analogique d'entrée comportant des zones correspondant à une évolution linéaire desdits signaux secondaires en fonction de celle du signal d'entrée exprimée dans une échelle logarithmique,
- plusieurs moyens de comparaison possédant respectivement plusieurs premières entrées respectivement connectées aux sorties de certains au moins des étages amplificateurs, plusieurs deuxièmes entrées configurées pour recevoir chacune un signal de référence commun dont la valeur se situe dans chacune desdites zones, et plusieurs sorties configurées pour délivrer une information de code thermométrique,
- des premiers moyens de conversion connectés aux sorties des moyens de comparaison et configurés pour délivrer un premier mot numérique à partir de l'information de code thermométrique.

Selon un mode de réalisation, la valeur du signal de référence est choisie telle que lorsqu'un signal secondaire de rang i dans ladite séquence prend la valeur égale à la valeur du signal de référence, la valeur correspondante du signal secondaire de rang i-1 se situe dans ladite zone de ce signal secondaire de rang i-1.

Selon un mode de réalisation, les premiers moyens de conversion comprennent un premier bloc de conversion configuré pour convertir l'information de code thermométrique en une information de code intermédiaire, un bit de rang i de l'information de code intermédiaire étant obtenu à partir du produit du complément du bit de rang i et du bit de rang i-1 ou de son complément de l'information de code thermométrique, et un deuxième bloc de conversion configuré pour convertir l'information de code intermédiaire en une information de code binaire formant ledit premier mot numérique.

Selon un mode de réalisation, les moyens de traitement comprennent en outre
- des moyens de multiplexage possédant plusieurs entrées respectivement connectées aux sorties de certains au moins des étages amplificateurs, une sortie et une entrée de commande connectée aux sorties des moyens de comparaison,
- des moyens secondaires de conversion analogique/numérique connectés à la sortie des moyens de multiplexage et configurés pour délivrer une information secondaire de code thermométrique, et
- des deuxièmes moyens de conversion configurés pour convertir l'information secondaire de code thermométrique en un deuxième mot numérique à partir du signal secondaire sélectionné délivré à la sortie des moyens de multiplexage, les premier et deuxième mots numériques formant respectivement des première et deuxième parties d'un mot numérique de sortie, la deuxième partie ayant un poids plus faible que la première partie.

Selon un mode de réalisation, ladite entrée de commande est couplée à la sortie du premier bloc de conversion.

Selon un mode de réalisation, toutes lesdites zones s'étendent au moins entre une première valeur limite inférieure commune et une première valeur limite supérieure commune et les moyens secondaires de conversion analogique/numérique comprennent un réseau de comparateurs secondaires configurés pour effectuer une comparaison du signal secondaire avec des seuils de référence régulièrement répartis entre ladite première valeur limite inférieure commune et ladite première valeur limite supérieure commune.

Selon un mode de réalisation, les moyens secondaires de conversion analogique/numérique comprennent un réseau de comparateurs secondaires configurés pour effectuer une comparaison du signal secondaire avec des seuils de référence régulièrement répartis entre une deuxième valeur limite inférieure plus faible que ladite première valeur limite inférieure commune et une deuxième valeur limite supérieure plus élevée que ladite première valeur limite supérieure commune, et le dispositif comprend en outre des moyens d'étalonnage configurés pour effectuer un étalonnage des moyens de traitement avec un signal analogique d'étalonnage en tant que signal d'entrée, ce signal d'étalonnage suivant une évolution temporelle monotone, les moyens d'étalonnage comportant des moyens d'élaboration configurés pour élaborer une table de correspondance entre les premiers et deuxièmes mots numériques successivement obtenus lors de la conversion analogique/numérique du signal d'étalonnage et des mots numériques de sortie désirés formant ensemble un code numérique binaire continu.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre très schématiquement un mode de réalisation d'un dispositif de conversion analogique/numérique selon l'invention,
- la figure 2 illustre une évolution du type exponentiel d'une tension analogique représentant une quantité physique ainsi qu'un code numérique binaire résultant de la conversion de cette tension analogique,
- les figures 3 et 4 illustrent schématiquement des variations d'un bit de poids faible par rapport à une variation de quantité physique dans un convertisseur analogique/numérique linéaire et dans un convertisseur analogique/numérique du type logarithmique, respectivement,

- la figure 5 illustre de façon plus détaillée, mais toujours schématique, un mode de réalisation d'un dispositif selon l'invention,
- les figures 6 à 18 illustrent plus en détail différentes parties du dispositif de la figure 5 ainsi que différents modes de mise en oeuvre d'un procédé de conversion analogique/numérique selon l'invention,
- les figures 19 à 24 illustrent schématiquement un autre mode de réalisation et un autre mode de mise en oeuvre de l'invention, et
- la figure 25 illustre schématiquement un exemple d'application d'un dispositif de conversion analogique/numérique selon l'invention.

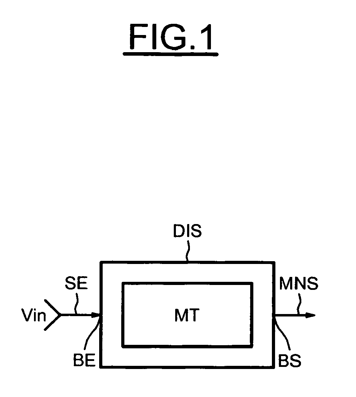

Sur la figure 1, la référence DIS désigne globalement un dispositif de conversion analogique/numérique selon l'invention. Ce dispositif DIS comporte des moyens d'entrée BE pour recevoir un signal analogique d'entrée SE, par exemple une tension analogique Vin.

Le dispositif comporte également une borne de sortie BS délivrant un mot numérique de sortie MNS correspondant au signal analogique d'entrée. Enfin, des moyens de traitement MT sont connectés entre les moyens d'entrée BE et les moyens de sortie BS.

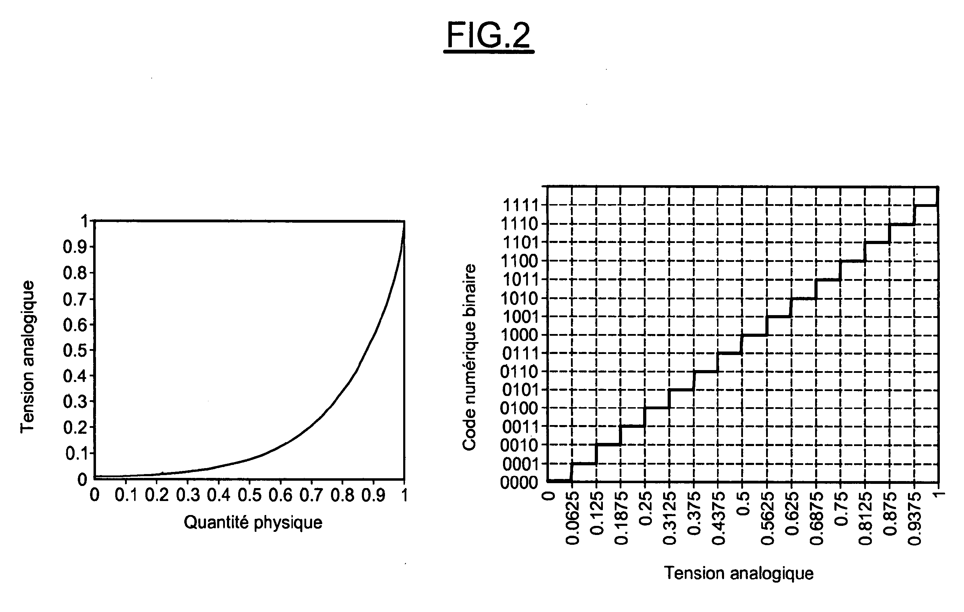

Le dispositif DIS est ici un dispositif de conversion analogique/numérique du type logarithmique car la tension analogique d'entrée Vin représente, comme illustré sur la partie gauche de la figure 2, une quantité physique, par exemple quantité électrique, thermique, ..., à travers une loi exponentielle. Le mot numérique de sortie MNS est par exemple l'un des mots numériques du code numérique binaire correspondant, après conversion analogique/numérique, à la tension analogique d'entrée, et illustré sur la partie droite de la figure 2.

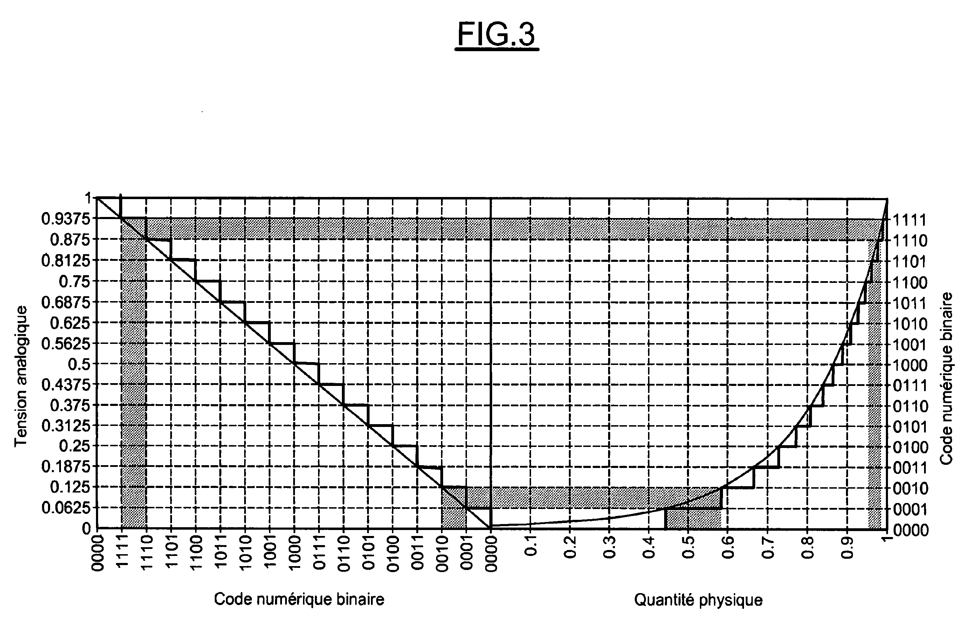

Comme illustré sur la figure 3, dans un convertisseur analogique/numérique linéaire classique, la variation d'un bit de poids faible d'un mot numérique de sortie ne représente pas la même variation de quantité physique selon que cette variation de bit de poids faible correspond à un mot numérique se situant dans la partie inférieure ou dans la partie supérieure du code numérique binaire.

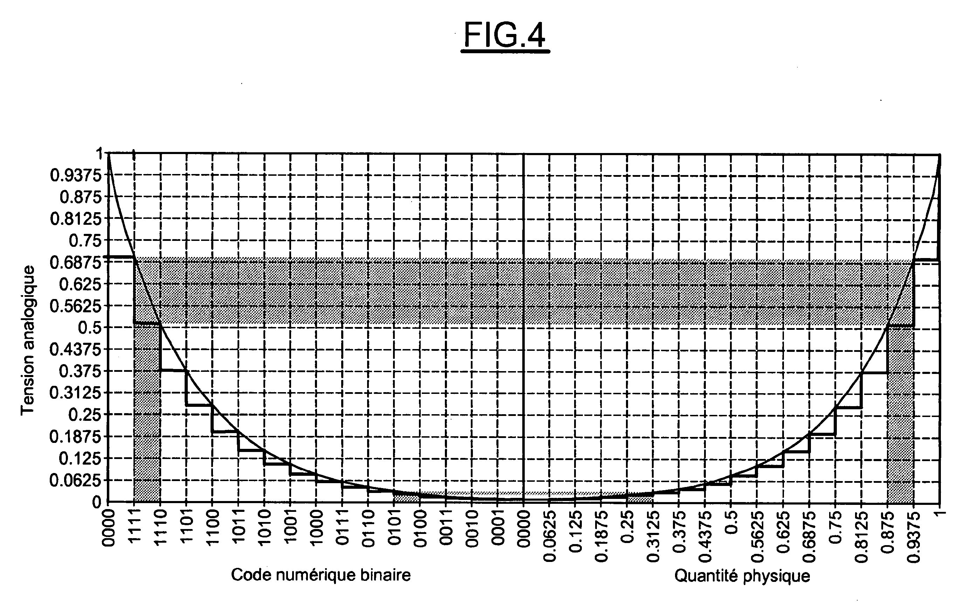

C'est la raison pour laquelle le dispositif DIS est un dispositif de conversion analogique numérique du type logarithmique pour lequel la variation d'un bit de poids faible dans un mot numérique du code numérique binaire de sortie représente la même variation de quantité physique quelle que soit la valeur de ce mot numérique de sortie (figure 4).

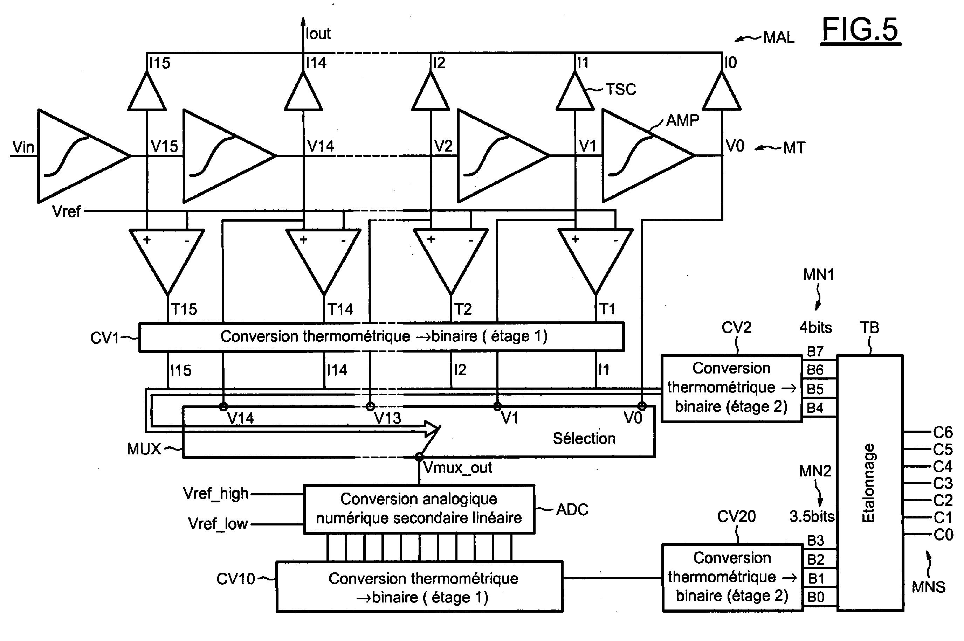

Comme illustré sur la figure 5, les moyens de traitement MT du dispositif DIS comprennent des moyens d'amplification logarithmique à compression progressive MAL, de structure classique et connue en soi.

Ces moyens MAL comportent une chaîne de plusieurs étages amplificateurs AMP, ici 16 étages amplificateurs, par exemple des amplificateurs de classe A ou AB, configurés pour délivrer chacun un signal analogique secondaire Vi. Dans l'exemple décrit ici, les moyens MAL délivrent donc 16 signaux analogiques secondaires V0-V15.

De façon classique, des éléments transconducteurs TSC sont connectés entre la sortie de chaque étage amplificateur AMP et la sortie analogique des moyens MAL. Ces éléments transconducteurs effectuent une conversion tension-courant, le courant analogique de sortie Iout étant égal à la somme des courants I0-I15 respectivement délivrés par les éléments transconducteurs TSC.

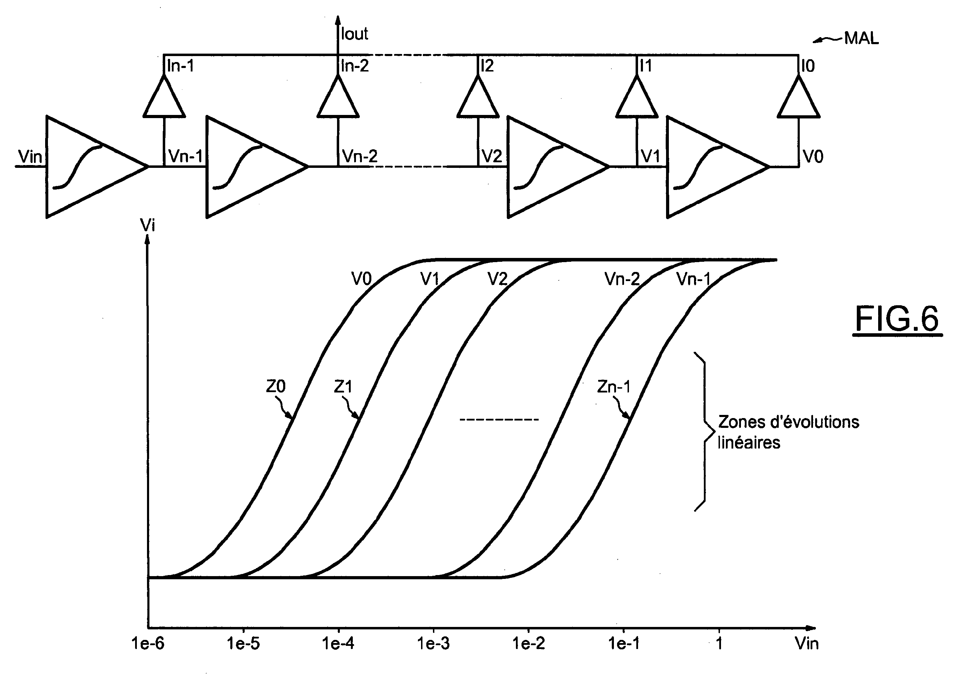

Généralement, comme illustré plus précisément sur la figure 6, l'évolution des valeurs de chaque signal analogique secondaire Vi, en fonction des valeurs du signal analogique d'entrée Vin, comporte une zone Zi correspondant à une évolution linéaire du signal secondaire Vi en fonction de celle du signal d'entrée Vin exprimée dans une échelle logarithmique.

Outre ces moyens d'amplification logarithmique à compression progressive MAL, les moyens de traitement comprennent plusieurs moyens de comparaison CMP, ici 15 moyens de comparaison ou comparateurs CMP.

Chaque comparateur comporte une première entrée, ici l'entrée positive, une deuxième entrée, ici l'entrée négative, ainsi qu'une sortie.

Les deuxièmes entrées des comparateurs reçoivent toutes un signal de référence commun, à savoir une tension de référence commune Vref.

Les premières entrées des comparateurs CMP sont connectées quant à elles aux sorties de certains des étages amplificateurs des moyens d'amplification MAL, à savoir aux sorties des 15 premiers étages de façon à recevoir respectivement les signaux analogiques secondaires V15-V1.

Lorsque, comme c'est le cas ici, on utilise au sein des moyens de traitement, comme on le verra plus en détail ci après, un convertisseur analogique/numérique secondaire ADC pour fournir les bits fins du mot numérique de sortie, il n'est nullement besoin de prévoir un seizième comparateur CMP qui serait destiné à comparer le signal secondaire V0 avec la tension de référence commune Vref car dans une telle application, l'information ainsi obtenue correspond au seuil minimum de conversion et est alors redondante avec l'information fournie par ce convertisseur analogique/numérique secondaire.

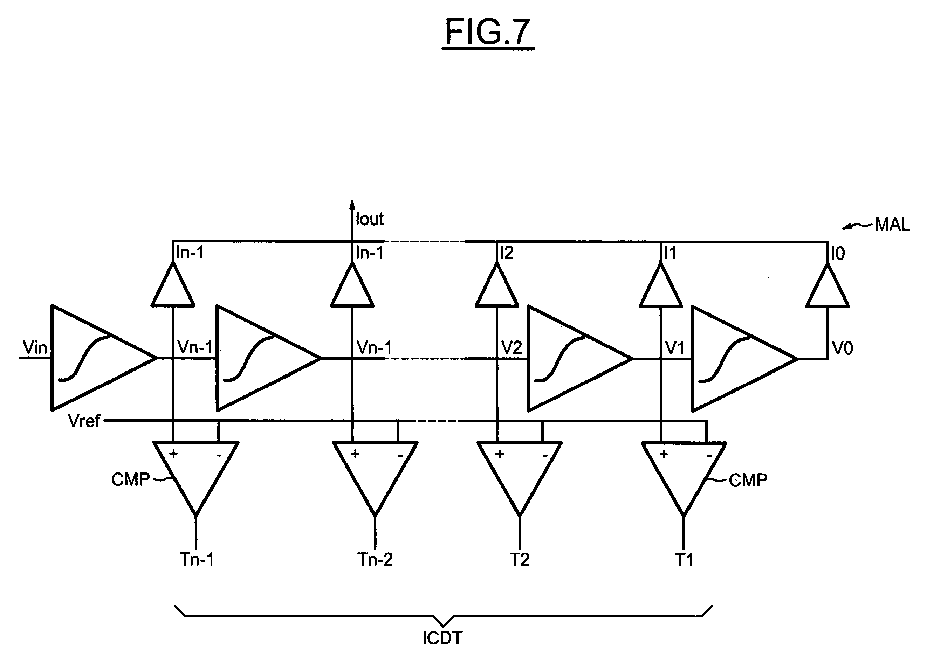

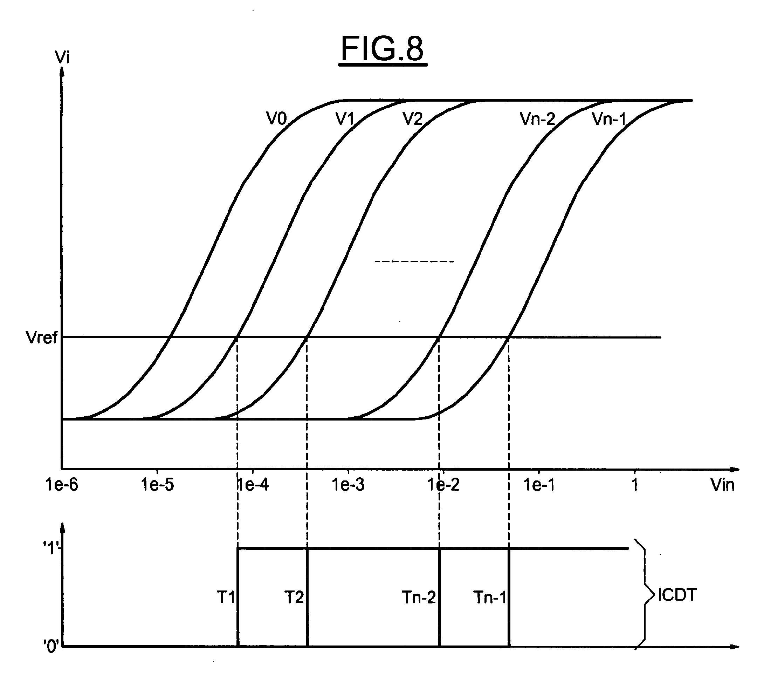

Comme illustré sur la figure 7 et sur la figure 8, les informations binaires T1 à Tn-1 (par exemple T1 à T15) forment ensemble une information de code thermométrique ICDT.

Plus précisément, lorsque le signal analogique secondaire Vi est supérieur à la tension de référence commune Vref, le bit correspondant Ti prend la valeur logique 1.

On rappelle ici qu'un code thermométrique est un code dans lequel le mot numérique formé des bits T1-Tn-1 est susceptible d'évoluer de la valeur minimale, pour laquelle tous les bits sont à zéro, à la valeur maximale, pour laquelle tous les bits sont à 1, par des passages successifs à 1 des différents bits depuis le bit de poids faible jusqu'au bit de poids fort.

En d'autres termes, un bit de poids donné ne peut pas passer à 1 si le bit de poids immédiatement inférieur n'est pas déjà passé à 1.

Un tel code est appelé « thermométrique » par analogie à la montée progressive du mercure dans un thermomètre.

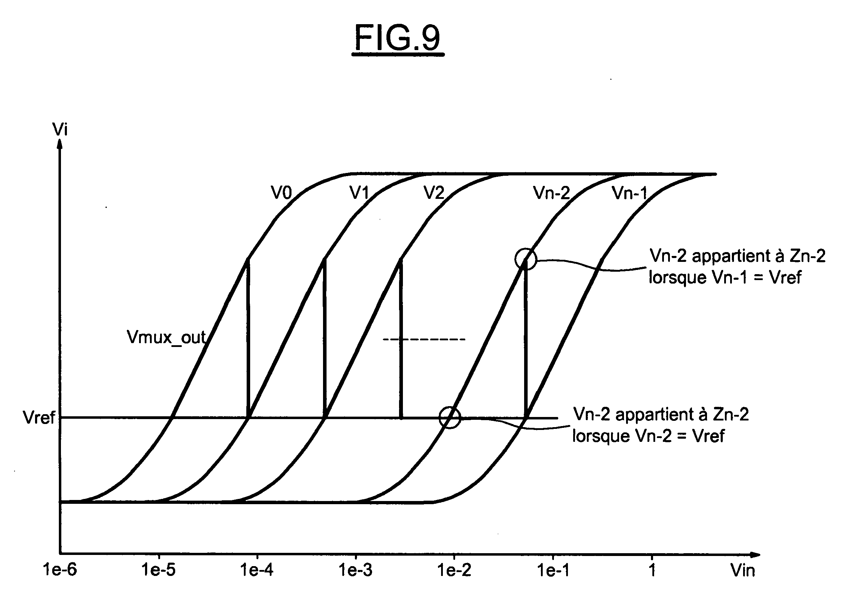

Comme illustré sur la figure 8 et sur la figure 9, la valeur du signal de référence Vref est choisie telle que sa valeur se situe dans chacune des zones linéaires d'un signal secondaire.

Par ailleurs, de façon à optimiser l'utilisation des zones linéaires Zi, cette valeur Vref est choisie telle que lorsqu'un signal secondaire de rang i prend la valeur égale à la valeur du signal de référence, la valeur correspondante du signal secondaire de rang i-1 se situe dans ladite zone linéaire Zi-1 de ce signal secondaire de rang i-1.

En pratique, la valeur de référence Vref est par exemple une valeur qui se situe au voisinage de la valeur inférieure de chaque zone linéaire Zi.

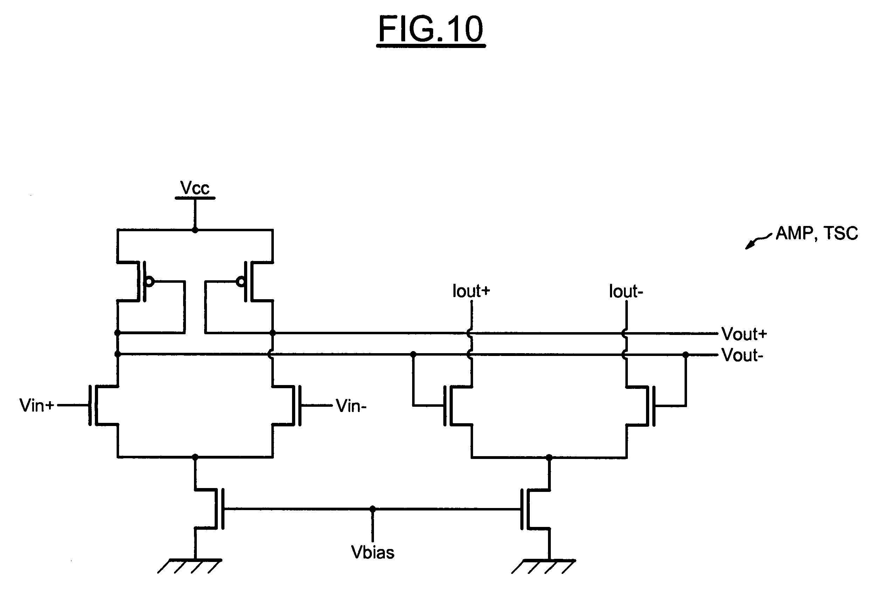

Comme il est classique et connu en soi, un exemple de réalisation d'un amplificateur AMP et de l'élément transconducteur TSC en structure différentielle, est illustré sur la figure 10. Sur cette figure, les tensions Vin+ et Vin- désignent la tension d'entrée différentielle de l'amplificateur tandis que les tensions Vout+ et Vout-désignent la tension de sortie différentielle. Les sorties Iout+ et Iout-désignent sur cette structure, la sortie différentielle de courant de l'élément TSC.

L'information de code thermométrique ICDT est convertie en un premier mot numérique MN1 (figure 5) par l'intermédiaire des premiers moyens de conversion connectés aux sorties des moyens de comparaison CMP.

Plus précisément, dans ce mode de réalisation, les premiers moyens de conversion comportent en fait deux étages de conversion CV1 et CV2.

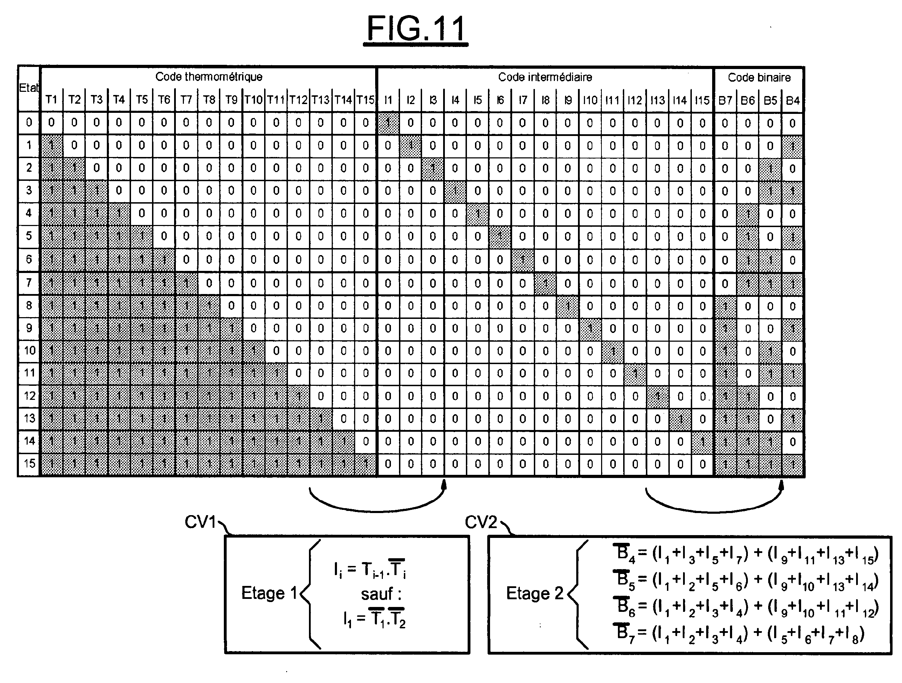

En effet, comme illustré sur la figure 11, l'information de code thermométrique est tout d'abord convertie en un code intermédiaire puis en un code binaire.

Les premiers moyens de conversion comprennent par conséquent un premier bloc de conversion CV1 pour convertir l'information de code thermométrique en une information de code intermédiaire I1-I15, en utilisant les équations mentionnées sur la figure 11.

Plus précisément, un bit Ii de rang i de l'information de code intermédiaire est obtenu à partir du produit *Tᵢ₋₁.Tᵢ* sauf en ce qui concerne le bit I1 qui est obtenu par le produit *T₁.T₂.*

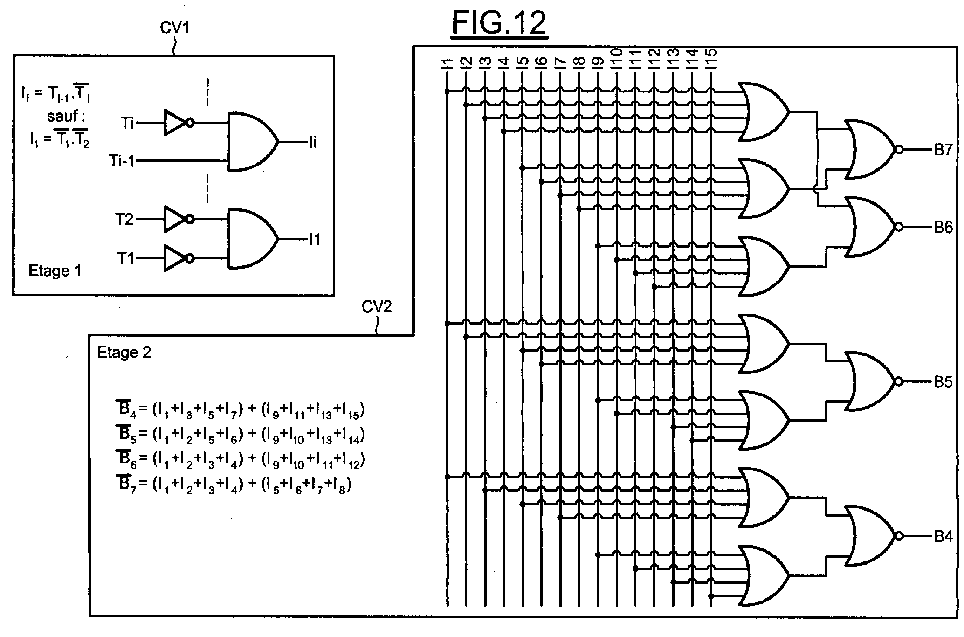

Comme illustré sur la figure 12, le bloc de conversion CV1 peut être réalisé simplement à partir d'inverseurs et de portes logiques ET.

Le deuxième bloc de conversion CV2 va convertir l'information de code intermédiaire I1-I15 en les bits, ici les quatre bits B₄-B₇, du premier mot numérique MN1 à partir des équations illustrées sur la figure 11.

Là encore, comme illustré sur la figure 12, le bloc CV2 peut être réalisé simplement à partir de portes logiques OU et NON-OU.

Ainsi, le convertisseur analogique/numérique logarithmique génère, entre chaque étage amplificateur, un signal analogique secondaire (tension) qui est généralement linéaire sur une courte section (par rapport à la tension d'entrée Vin exprimée dans une échelle logarithmique). En comparant toutes les tensions ainsi générées à une tension de référence, on obtient un code thermométrique qui indique dans quelle section est située la tension d'entrée. Le code thermométrique est ensuite converti en un code binaire pour former les bits du premier mot numérique MN1. Ces bits forment des bits « grossiers ».

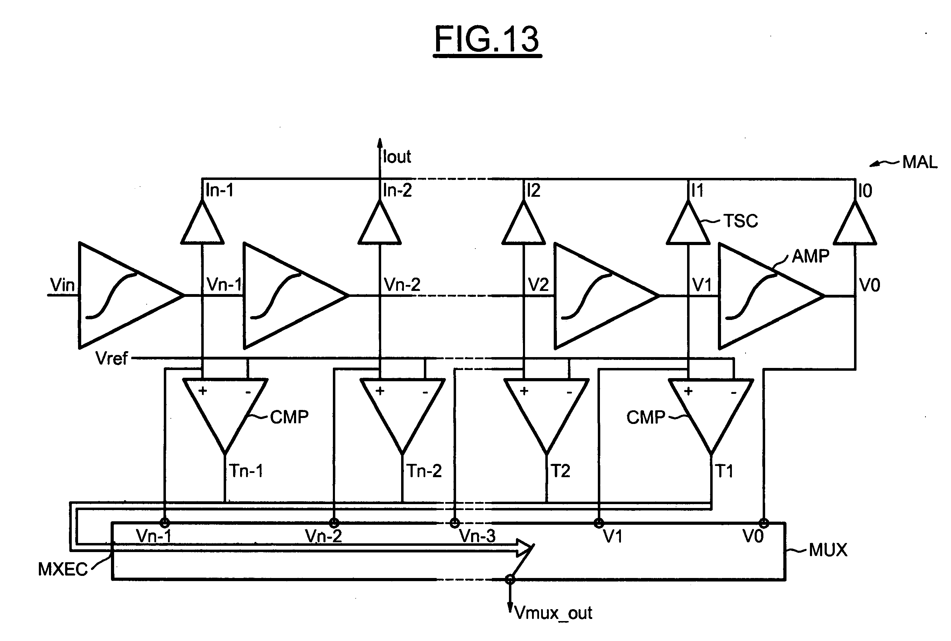

Cela étant, lorsque dans certaines applications, il est nécessaire d'avoir une résolution plus fine, il est prévu, comme illustré sur la figure 13, que les moyens de traitement comprennent en outre des moyens de multiplexage MUX possédant plusieurs entrées généralement respectivement connectées aux sorties des étages amplificateurs.

C'est le cas illustré sur la figure 13.

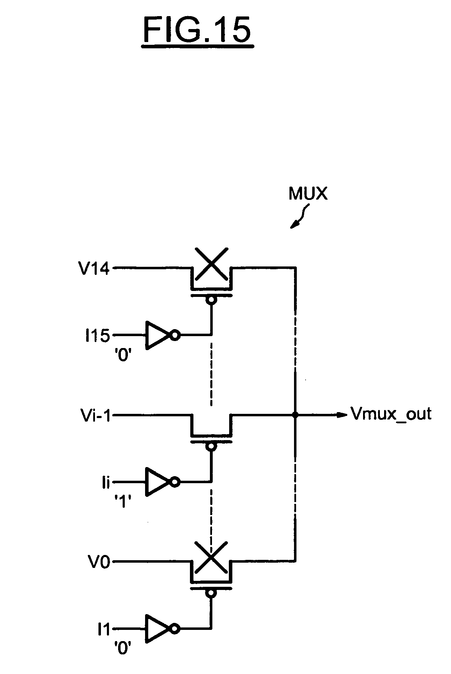

Cela étant, dans certaines implémentations pratiques, il est possible que le signal secondaire Vn-1 (le signal V15 dans le cas de la figure 15) comporte une zone linéaire trop petite pour être correctement exploitable. Dans ce cas, la sélection du signal V15 qui devrait être faite lorsque tous les bits de T1 à T15 sont à 1, n'est pas implémentée. C'est le cas illustré sur la figure 5.

Ainsi, dans ce cas, les moyens de multiplexage possèdent plusieurs entrées respectivement connectées aux sorties de certains seulement des étages amplificateurs, de façon à recevoir certains seulement des signaux analogiques secondaires, à savoir, dans le cas présent, les signaux V0-V14.

Le multiplexeur MUX comporte également une sortie délivrant le signal Vmux_out qui va être l'un des signaux secondaires présents à l'entrée du multiplexeur MUX.

Le multiplexeur MUX comporte également une entrée de commande MXEC reliée à la sortie des moyens de comparaison CMP.

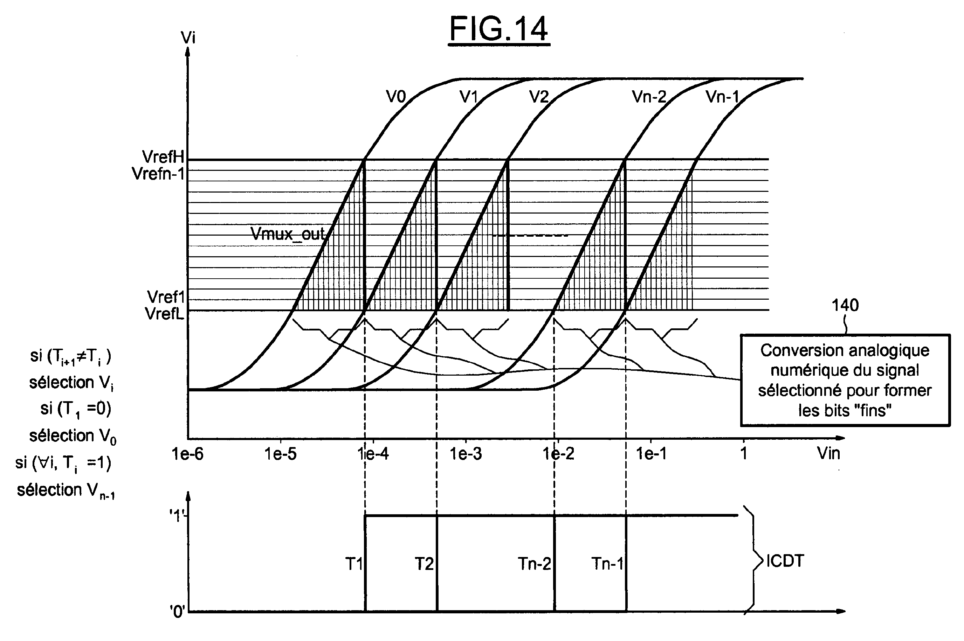

Ainsi, comme illustré sur la figure 14, si Tᵢ₊₁ est différent de Tᵢ, on sélectionne alors le signal Vi.

Si T1 est égal à 0, on sélectionne le signal V0 et, si quel que soit i, Tᵢ est égal à 1, alors on sélectionne le signal Vn-1.

Puis, le signal sélectionné Vmux_out va subir une conversion analogique/numérique 140 pour former les bits « fins » B0, B1, B2, B3 d'un deuxième mot numérique MN2.

Ainsi, le mot numérique de sortie MNS du convertisseur analogique/numérique logarithmique est formé du premier mot numérique MN1 et du deuxième mot numérique MN2, les bits B0-B3 du mot numérique MN2 ayant un poids plus faible que les bits B4-B7 du mot numérique MN1.

Lorsque, comme illustré sur la figure 5, il est prévu une conversion de l'information thermométrique T1-T15 vers les bits du mot numérique MN1 en deux étages CV1-CV2, l'entrée de commande du multiplexeur MUX est connectée directement aux bits 11-115 du code intermédiaire, et par conséquent indirectement aux bits T1-T15 du code thermométrique.

Un exemple de réalisation du multiplexeur MUX est alors illustré sur la figure 15. On voit que le multiplexeur MUX comporte ici des transistors PMOS dont les grilles forment l'entrée de commande de ce multiplexeur MUX.

Lorsque notamment l'étage de comparateurs CMP est suffisamment précis, toutes les zones « linéaires » des signaux secondaires analogiques Vi s'étendent, comme illustré sur la figure 14, entre une première limite inférieure commune VrefL, qui est prise en général égale à la tension de référence commune Vref, et une valeur limite supérieure commune VrefH.

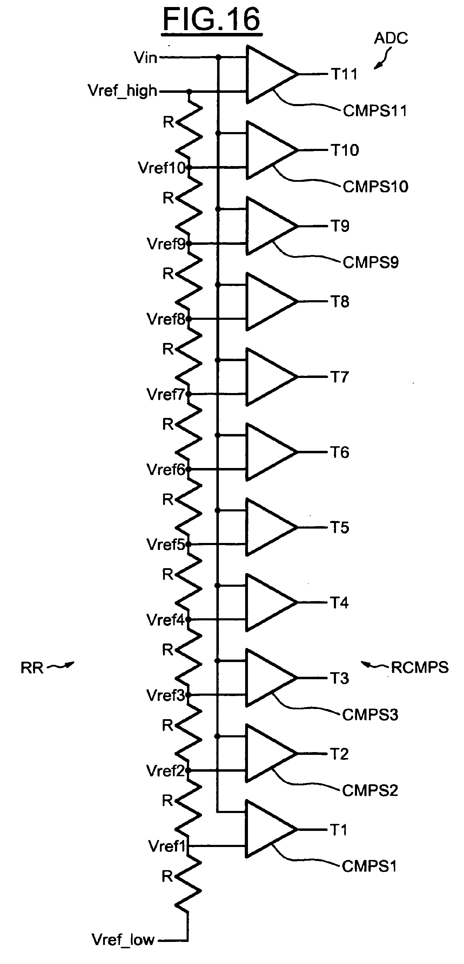

Les moyens secondaires de conversion analogique/numérique ADC comprennent alors, comme illustré sur la figure 16, un réseau de comparateurs secondaires RCMPS configurés pour effectuer une comparaison du signal secondaire sélectionné par le multiplexeur MUX avec des seuils de référence régulièrement répartis entre lesdites valeurs VrefL et VrefH. Ces seuils de référence Vrefi sont délivrés au niveau des noeuds intermédiaires d'un réseau résistif RR.

Et, lorsque l'étage de comparaison CMP et le multiplexeur analogique MUX n'introduisent pas d'erreur ou introduisent une erreur qui est considérée comme acceptable dans l'application envisagée, il est alors suffisant d'utiliser, dans l'exemple décrit ici, sept comparateurs secondaires CMPS3-CMPS9 délivrant sept bits T3-T9 formant également une information de code thermométrique.

Cela étant, lorsqu'on souhaite prendre en compte l'imprécision générée par les comparateurs CMP et le multiplexeur analogique MUX, il est préférable, comme illustré sur la figure 16, que les seuils de référence Vrefi soient régulièrement répartis entre une valeur limite inférieure Vref_low plus faible que la valeur VrefL de la figure 14 et une valeur limite supérieure Vref_high plus grande que la valeur limite VrefH de la figure 14.

Ceci revient à rajouter aux extrémités de l'échelle de conversion, des niveaux de seuils supplémentaires matérialisés ici par quatre comparateurs secondaires supplémentaires, à savoir les comparateurs secondaires CMPS1, CMPS2 et CMPS10, CMPS11.

Il devient alors nécessaire, comme on le verra plus en détail ci après, d'effectuer une procédure d'étalonnage de façon à ce que l'ensemble des mots numériques de sortie désirés forment ensemble un code numérique binaire continu. On reviendra plus en détail ci après sur cet aspect.

Donc, comme illustré sur la figure 16, lorsqu'on utilise des comparateurs secondaires supplémentaires, on obtient en sortie du convertisseur analogique/numérique ADC une information de code thermométrique formée de 11 bits T1-T11.

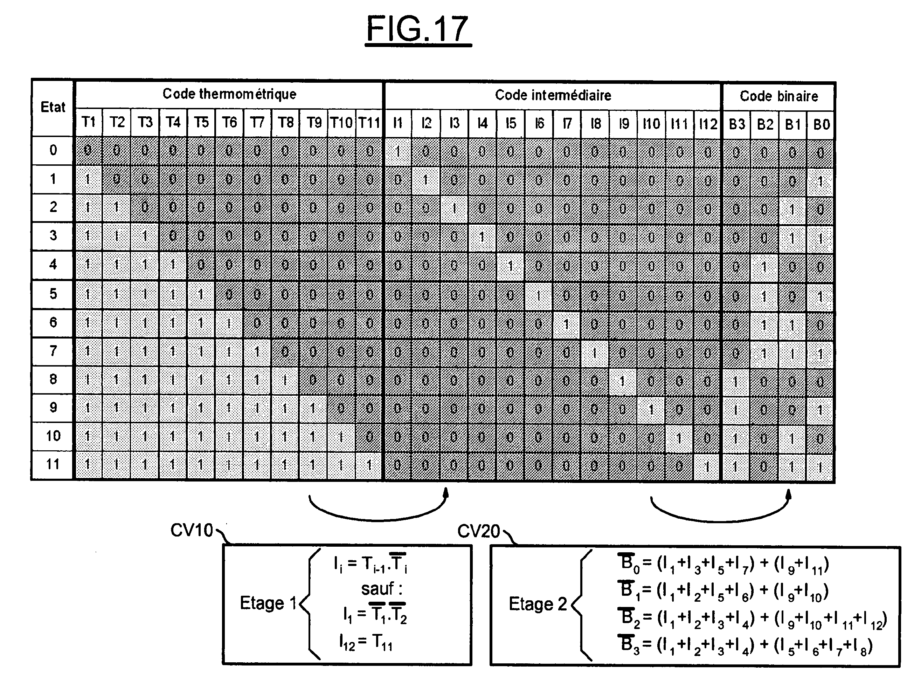

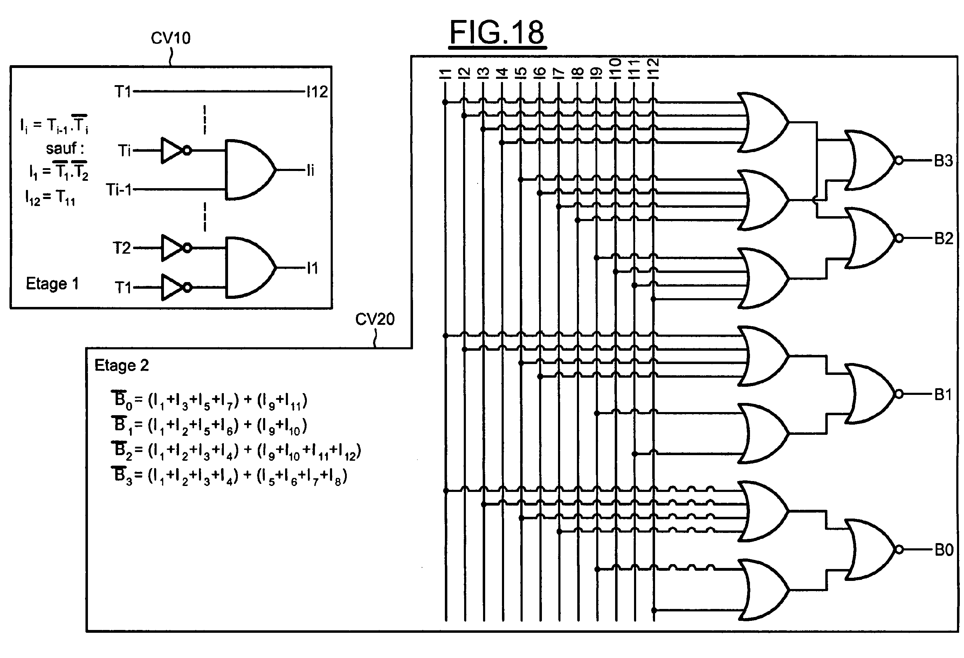

D'une façon analogue à ce qui a été décrit précédemment, cette information de code thermométrique T1-T11 est, comme illustré sur la figure 5 mais également sur les figures 17 et 18, convertie en le deuxième mot numérique MN2 par deux étages de conversion CV10 et CV20 formant des deuxièmes moyens de conversion.

Plus précisément, l'étage CV10 fournit un code intermédiaire à partir du code thermométrique, en utilisant les équations mentionnées sur la figure 17 tandis que le deuxième étage de conversion CV20 transforme le code intermédiaire I1-I12 en les quatre bits B0-B3 du mot numérique MN2 au moyen des équations également mentionnées sur la figure 17. Cela étant, comme illustré sur la figure 17, puisqu'il n'y a que 12 bits I1 à I12, les quatre bits B0-B3 ne prennent pas toutes les 16 valeurs possibles, mais seulement 12, ce qui correspond donc fictivement à 3,5 bits (≃2^{3,5}).

Matériellement, comme illustré sur la figure 18, les étages CV10 et CV20 peuvent être par exemple réalisés au moyen de circuits logiques comportant des inverseurs et des portes logiques.

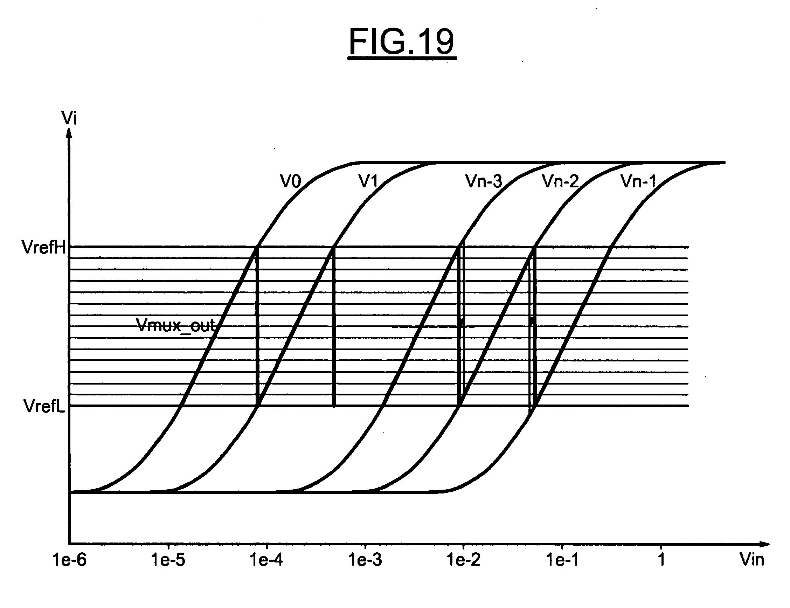

On revient maintenant, en se référant plus particulièrement aux figures 19 à 24, à l'étalonnage du dispositif de conversion analogique numérique logarithmique DIS évoqué précédemment.

La linéarité du dispositif DIS dépend de la corrélation entre les bits grossiers et les bits fins qui résulte notamment directement de la précision des comparateurs CMP.

Plus précisément, comme illustré sur la figure 19, une erreur dans la conversion grossière va induire une erreur sur le segment sélectionné du signal analogique secondaire. Par conséquent, la sortie Vmux_out du multiplexeur MUX risque d'excéder la plage de conversion du convertisseur analogique numérique secondaire ADC.

En effet, comme illustré sur la figure 19, certains segments réellement sélectionnés peuvent avoir des niveaux dépassant le seuil VrefH ou le seuil VrefL.

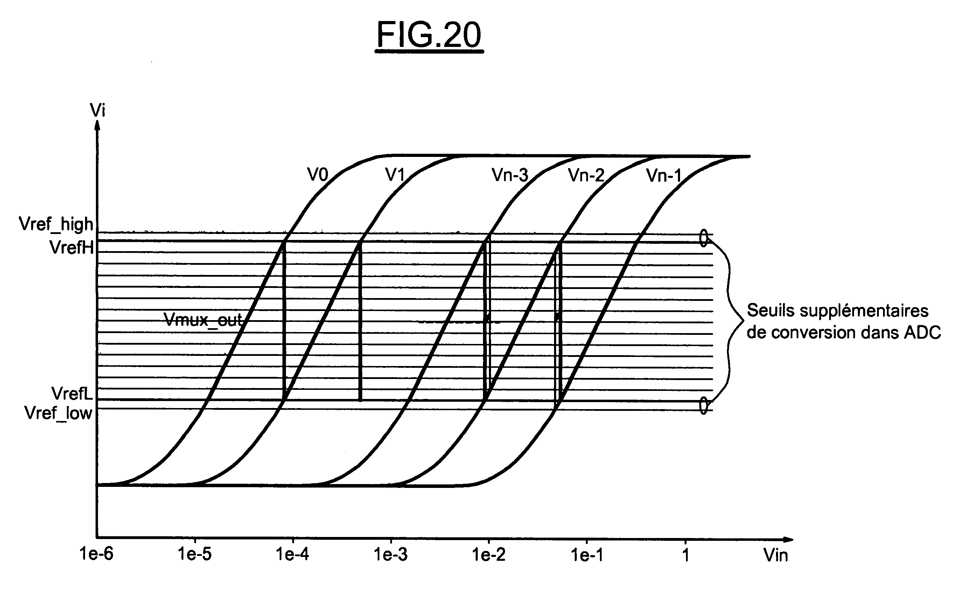

C'est la raison pour laquelle, afin de résoudre ce problème, on prévoit, comme illustré sur la figure 20, des seuils supplémentaires de conversion dans le convertisseur analogique/numérique secondaire ADC. Tous les seuils de conversion vont alors être régulièrement situés entre le seuil bas Vref_low et le seuil haut Vref_high.

Ceci se traduit dans l'exemple particulier de réalisation illustré sur la figure 16, par le réseau de 11 comparateurs secondaires CMPSi délivrant les 11 bits de l'information thermométrique T1-T11.

Cela étant, certaines valeurs de code n'apparaîtront jamais en raison de l'adjonction de ces niveaux de seuils supplémentaires de conversion.

C'est la raison pour laquelle il est prévu d'effectuer un étalonnage du convertisseur de façon à corréler les bits fins et les bits grossiers pour former un unique code numérique continu de sortie.

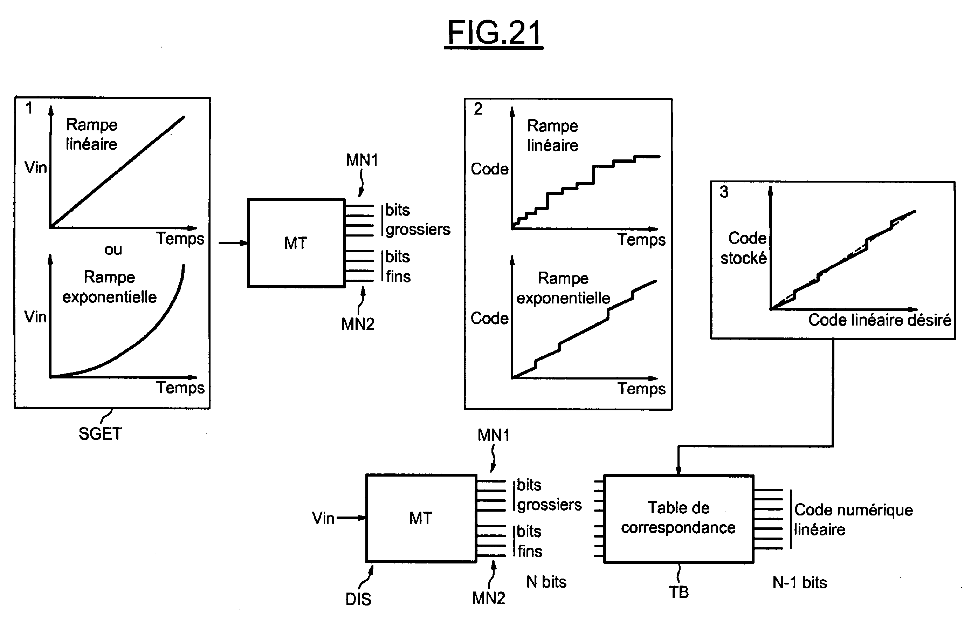

Un exemple de procédure d'étalonnage est illustré sur la figure 21.

Plus précisément, on applique en entrée des moyens de traitement MT du dispositif DIS, un signal d'entrée SGET (signal d'étalonnage) en forme de rampe monotone et continue. Cette rampe peut être une rampe linéaire ou bien une rampe exponentielle ou encore toute fonction monotone.

Une rampe exponentielle va conduire à une évolution régulière dans le temps de la sortie tandis qu'une rampe linéaire va induire une évolution logarithmique de la sortie.

On stocke ensuite le code (bits grossiers et bits fins) obtenu et on établit une table de correspondance entre le code stocké et le code linéaire (continu) désiré en tenant compte des valeurs de code qui ne doivent pas apparaître. Cette table de correspondance TB permet ainsi pour tout mot numérique de N bit formé des bits grossiers et des bits fins délivrés par les moyens de traitement MT, de délivrer un mot numérique de sortie MNS sur N-1 bit, l'ensemble des mots numériques de sortie formant alors un code numérique linéaire c'est-à-dire continu.

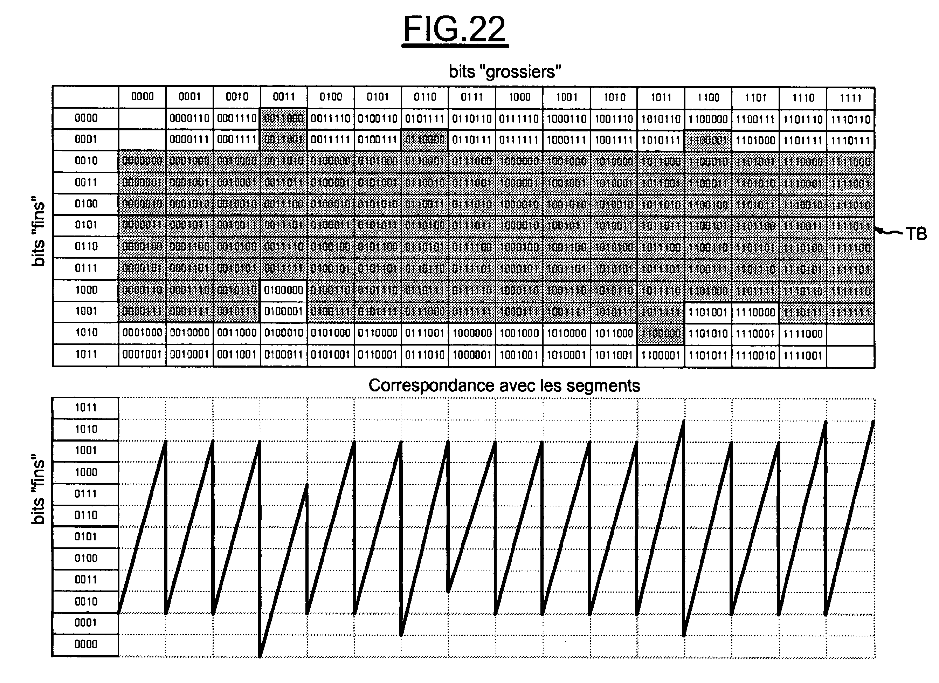

Un exemple de table de correspondance TB est donné sur la figure 22. Ainsi, on voit, en correspondance avec les segments (zones linéaires), illustrés sur la partie basse de la figure 22, que le code débute à la valeur 0000000 correspondant à la valeur 0010 pour le mot numérique MN2 (bits fins) et à la valeur 0000 pour le mot numérique MN1 (bits grossiers), et se termine à la valeur 1111111 correspondant aux valeurs 1001 pour les bits fins et aux valeurs 1111 pour les bits grossiers.

Le code de sortie contenu dans la table TB prend donc toutes les valeurs comprises entre la valeur initiale et la valeur finale.

Par contre, les valeurs de code situées à l'extérieur de cette table sont des valeurs qui ne doivent pas se produire compte tenu de l'évolution des différents segments. Ainsi, à titre d'exemple, la valeur 0001000 correspondant aux valeurs 1010 pour les bits fins et aux valeurs 0000 pour les bits grossiers ne doit pas se produire. Par contre, cette valeur de code 001000 correspond maintenant aux valeurs 0010 des bits fins et aux valeurs 0001 des bits grossiers et permet d'assurer la continuité du code numérique défini par le contenu de la table TB.

La continuité linéaire du code est par conséquent préservée.

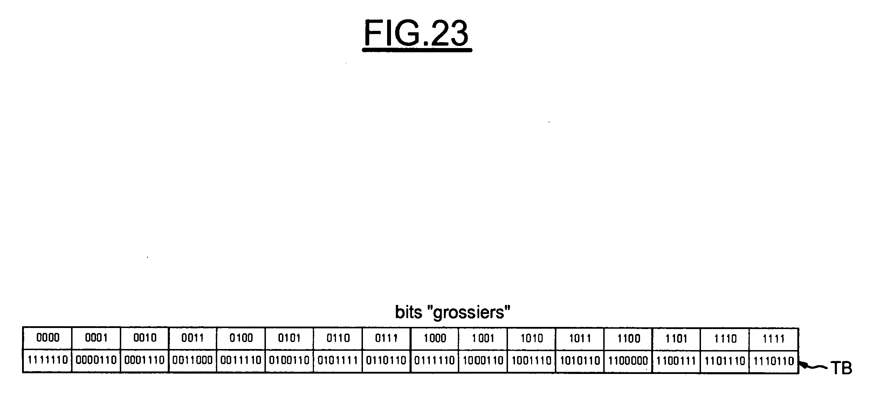

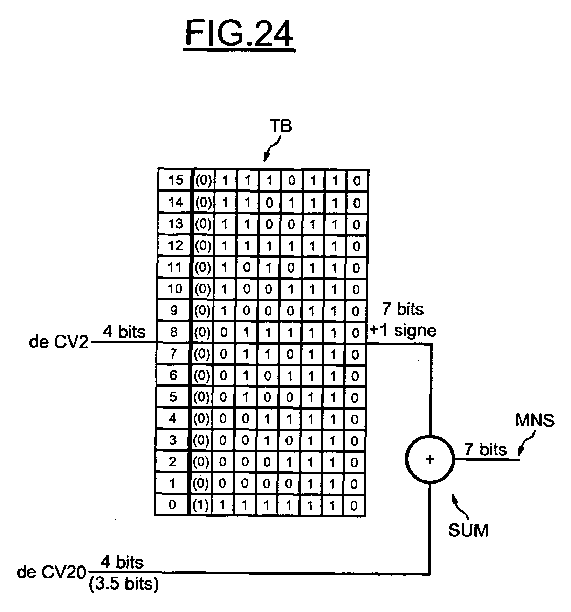

Une première solution peut consister à stocker la totalité de la table TB qui va fournir en sortie, dans l'exemple considéré, 7 bits de code (les bits C0-C6 du mot de sortie MNS de la figure 5) pour chaque combinaison des bits grossiers et des bits fins. Une autre solution, plus optimisée, consiste simplement à stocker une table TB de taille plus réduite, telle que celle illustrée sur la figure 23. Cette table TB fournit un code de 7 bits pour les différentes valeurs des bits grossiers, les différents éléments de cette table devant juste être additionnés aux bits fins pour former les bits du mot de sortie, comme illustré sur la figure 24.

Plus précisément, le mot de sortie MNS de 7 bits est obtenu par sommation dans un sommateur SUM, des bits B0-B3 délivrés par l'étage de conversion CV20 et d'un mot de 7 bits extrait de la table TB qui est stockée dans une mémoire morte. Les différents mots stockés dans la table TB sont sélectionnés par la valeur des bits B4-B7 délivrés par le bloc de conversion CV2, qui définissent les adresses dans la mémoire de stockage.

Une façon pour obtenir cette table optimisée consiste à appliquer une rampe de tension à l'entrée du convertisseur analogique/numérique logarithmique DIS. Les moyens d'étalonnage comportent alors un compteur configuré pour compter le nombre de modifications dans les valeurs des bits du mot numérique MN2 (bits fins). La valeur correspondante du mot MN2 est soustraite, dans un soustracteur, à la valeur correspondante du compteur lors de chaque modification de valeur du mot MN1 (bits grossiers) et le résultat de cette soustraction est stocké dans la table.

Il convient de noter ici que cette procédure d'étalonnage peut être effectuée in situ au sein même du dispositif DIS (on parle alors d'auto-étalonnage) ou bien lors de la fabrication du dispositif.

Le dispositif qui vient d'être décrit présente une grande plage de conversion dynamique qui dépend du nombre d'amplificateurs des moyens MAL. Il en résulte par conséquent une grande flexibilité de réalisation qui est encore importante par le caractère facultatif des éléments mettant en oeuvre la conversion fine.

La bande passante fréquentielle du dispositif est uniquement fixée par celle des amplificateurs.

La structure du dispositif offre une faible consommation de courant sous des tensions d'alimentations faibles, par exemple 1,2 Volts.

Le dispositif DIS qui vient d'être décrit peut par ailleurs aisément être réalisée sous forme intégrée au sein d'un circuit intégré pouvant contenir d'autre blocs fonctionnels. Il présente par ailleurs une surface réduite, par exemple inférieure à 0,02 mm² dans une technologie CMOS 65nm.

Il peut être par exemple aisément intégré dans une chaîne de réception radiofréquence logicielle.

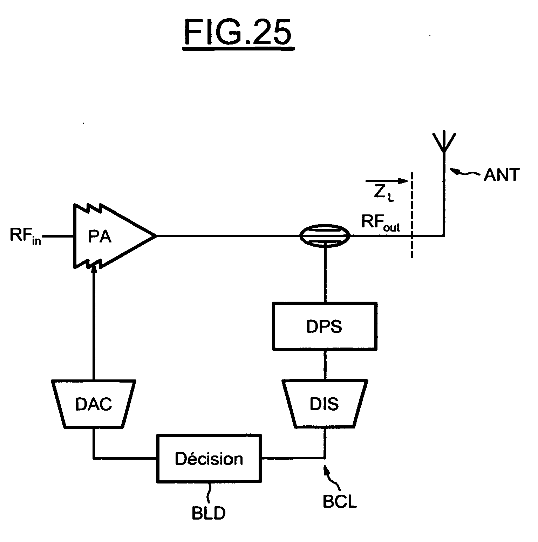

Un autre exemple d'application du dispositif DIS est illustré sur la figure 25.

L'application décrite ici vise plus particulièrement les architectures radiofréquences 60 GHz W-HDMI et concerne un amplificateur de puissance PA régulé au moyen d'une boucle de régulation numérique BCL travaillant à 1 MHz. La chaîne d'émission comporte un détecteur DPS de la puissance du signal RFₒᵤₜ délivré par l'amplificateur de puissance PA, le dispositif DIS décrit précédemment, un bloc de décision BLD et un convertisseur numérique analogique DAC. Il est ainsi possible de compenser un désappariement de l'impédance d'antenne ANT connu par l'homme du métier sous la dénomination de VSWR (Voltage Standing Wave Ratio).

## Revendications

1. Procédé de conversion analogique/numérique du type logarithmique d'un signal analogique d'entrée, **caractérisé en ce qu'**il comprend une amplification logarithmique à compression progressive (MAL) du signal analogique d'entrée (Vin) délivrant une séquence de plusieurs signaux analogiques secondaires (Vi), l'évolution des valeurs de certains au moins des signaux analogiques secondaires en fonction des valeurs du signal analogique d'entrée comportant des zones (Zi) correspondant à une évolution linéaire des signaux analogiques secondaires en fonction de celle du signal analogique d'entrée exprimée dans une échelle logarithmique, une comparaison (CMP) de certains au moins des signaux analogiques secondaires de ladite séquence avec un signal de référence commun (Vref) dont la valeur se situe dans chacune desdites zones, fournissant une information de code thermométrique (IDTC), et une élaboration d'un premier mot numérique (MN1) à partir de l'information de code thermométrique.

2. Procédé selon la revendication 1, dans lequel la valeur du signal de référence (Vref) est choisie telle que lorsqu'un signal secondaire de rang i dans ladite séquence prend la valeur égale à la valeur du signal de référence, la valeur correspondante du signal secondaire de rang i-1 se situe dans ladite zone de ce signal secondaire de rang i-1.

3. Procédé selon la revendication 1 ou 2, dans lequel la valeur du signal de référence (Vref) est une valeur se situant au voisinage de la valeur inférieure de chaque zone.

4. Procédé selon l'une des revendications précédentes, dans lequel l'élaboration du premier mot numérique (MN1) comprend une conversion de l'information de code thermométrique (IDTC) en une information de code intermédiaire (Ii), un bit (Ii) de rang i de l'information de code intermédiaire étant obtenu à partir du produit du complément du bit de rang i et du bit de rang i-1 ou de son complément, de l'information de code thermométrique, et une conversion de l'information de code intermédiaire en une information de code binaire (B3-B7) formant ledit premier mot numérique (MN1).

5. Procédé selon l'une des revendications précédentes, comprenant en outre une sélection (MUX) de l'un des signaux secondaires (Vi) de la séquence à partir de l'information de code thermométrique (IDTC), une conversion analogique/numérique secondaire (ADC) du signal secondaire sélectionné en une information secondaire de code thermométrique (T1-T11) et une conversion (CV10, CV20) de l'information secondaire de code thermométrique en un deuxième mot numérique (MN2), les premier et deuxième mots numériques formant respectivement des première et deuxième parties d'un mot numérique de sortie (MNS), la deuxième partie ayant un poids plus faible que la première partie.

6. Procédé selon les revendications 4 et 5, dans lequel ladite sélection du signal secondaire est effectuée à partir de l'information de code intermédiaire (Ii).

7. Procédé selon l'une des revendications 5 ou 6, dans lequel toutes lesdites zones (Zi) s'étendent au moins entre une première valeur limite inférieure commune (VrefL) et une première valeur limite supérieure commune (VrefH) et la conversion analogique/numérique secondaire (ADC) du signal secondaire sélectionné comprend une comparaison du signal secondaire avec des seuils de référence régulièrement répartis entre ladite première valeur limite inférieure commune et ladite première valeur limite supérieure commune.

8. Procédé selon la revendication 7, dans lequel la conversion analogique/numérique secondaire (ADC) du signal secondaire sélectionné comprend une comparaison du signal secondaire avec des seuils de référence régulièrement répartis entre une deuxième valeur limite inférieure (Vref_low) plus faible que ladite première valeur limite inférieure commune (VrefL) et une deuxième valeur limite supérieure (Vref_high) plus élevée que ladite première valeur limite supérieure commune (VrefH), et le procédé comprend en outre un étalonnage de ladite conversion analogique/numérique avec un signal analogique d'étalonnage (SGET) en tant que signal d'entrée, ce signal d'étalonnage suivant une évolution temporelle monotone, et une élaboration d'une table de correspondance (TB) entre les premiers et deuxièmes mots numériques (MN1, MN2) successivement obtenus lors de la conversion analogique/numérique du signal d'étalonnage et des mots numériques de sortie désirés (MNS) formant ensemble un code numérique binaire continu (C0-C7)

9. Dispositif de conversion analogique/numérique logarithmique, comportant des moyens d'entrée (BE) configurés pour recevoir un signal d'entrée analogique (Vin) et des moyens de traitement (MT) connectés aux moyens d'entrée, **caractérisé en ce que** les moyens de traitement (MT) comprennent des moyens d'amplification logarithmique à compression progressive (MAL) connectés aux moyens d'entrée configurés pour délivrer une séquence de signaux analogiques secondaires et comportant
- une chaîne de plusieurs étages amplificateurs (AMP) configurés pour délivrer chacun un signal analogique secondaire (Vi) de ladite séquence, l'évolution des valeurs de certains au moins des signaux analogiques secondaires en fonction des valeurs du signal analogique d'entrée comportent des zones (Zi) correspondant à une évolution linéaire des signaux analogiques secondaires en fonction de celle du signal analogique d'entrée exprimée dans une échelle logarithmique,
- plusieurs moyens de comparaison (CMP) possédant respectivement plusieurs premières entrées (+) respectivement connectées aux sorties de certains au moins des étages amplificateurs, plusieurs deuxièmes entrées (-) configurées pour recevoir chacune un signal de référence commun (Vref) dont la valeur se situe dans chacune desdites zones, et plusieurs sorties configurées pour délivrer une information de code thermométrique (IDTC),
- des premiers moyens de conversion (CV1, CV2) connectés aux sorties des moyens de comparaison et configurés pour délivrer un premier mot numérique (MN1) à partir de l'information de code thermométrique (IDTC).

10. Dispositif selon la revendication 9, dans lequel la valeur du signal de référence (Vref) est choisie telle que lorsqu'un signal secondaire de rang i dans ladite séquence prend la valeur égale à la valeur du signal de référence, la valeur correspondante du signal secondaire de rang i-1 se situe dans ladite zone de ce signal secondaire de rang i-1.

11. Dispositif selon la revendication 9 ou 10, dans lequel la valeur du signal de référence (Vref) est une valeur se situant au voisinage de la valeur inférieure de chaque zone.

12. Dispositif selon l'une des revendications 9 à 11, dans lequel les premiers moyens de conversion comprennent un premier bloc de conversion (CV1) configuré pour convertir l'information de code thermométrique (IDTC) en une information de code intermédiaire (Ii), un bit de rang i de l'information de code intermédiaire étant obtenu à partir du produit du complément du bit de rang i et du bit de rang i-1 ou de son complément, de l'information de code thermométrique, et un deuxième bloc de conversion (CV2) configuré pour convertir l'information de code intermédiaire en une information de code binaire formant ledit premier mot numérique (MN1).

13. Dispositif selon l'une des revendications 9 à 12, dans lequel les moyens de traitement (MT) comprennent en outre des moyens de multiplexage (MUX) possédant plusieurs entrées respectivement connectées aux sorties de certains au moins des étages amplificateurs (AMP), une sortie et une entrée de commande (MXEC) connectée aux sorties des moyens de comparaison, des moyens secondaires de conversion analogique/numérique (ADC) connectés à la sortie des moyens de multiplexage et configurés pour délivrer une information secondaire de code thermométrique, (T1-T11) et des deuxièmes moyens de conversion (CV10, CV20) configurés pour convertir l'information secondaire de code thermométrique (T1-T11) en un deuxième mot numérique (MN2) à partir du signal secondaire sélectionné délivré à la sortie des moyens de multiplexage, les premier et deuxième mots numériques formant respectivement des première et deuxième parties d'un mot numérique de sortie (MNS), la deuxième partie ayant un poids plus faible que la première partie.

14. Dispositif selon les revendications 12 et 13, dans lequel ladite entrée de commande (MXEC) est couplée à la sortie du premier bloc de conversion (CV1).

15. Dispositif selon l'une des revendications 13 ou 14, dans lequel toutes lesdites zones (Zi) s'étendent au moins entre une première valeur limite inférieure commune et une première valeur limite supérieure commune et les moyens secondaires de conversion analogique/numérique comprennent un réseau de comparateurs secondaires (CMPSi) configurés pour effectuer une comparaison du signal secondaire avec des seuils de référence régulièrement répartis entre ladite première valeur limite inférieure commune et ladite première valeur limite supérieure commune.

16. Dispositif selon la revendication 15, dans lequel les moyens secondaires de conversion analogique/numérique comprennent un réseau de comparateurs secondaires (CMPSi) configurés pour effectuer une comparaison du signal secondaire avec des seuils de référence régulièrement répartis entre une deuxième valeur limite inférieure plus faible que ladite première valeur limite inférieure commune et une deuxième valeur limite supérieure plus élevée que ladite première valeur limite supérieure commune, et le dispositif comprend en outre des moyens d'étalonnage configurés pour effectuer un étalonnage des moyens de traitement avec un signal analogique d'étalonnage (SGET) en tant que signal d'entrée, ce signal d'étalonnage suivant une évolution temporelle monotone, les moyens d'étalonnage comportant des moyens d'élaboration configurés pour élaborer une table de correspondance (TB) entre les premiers et deuxièmes mots numériques successivement obtenus lors de la conversion analogique/numérique du signal d'étalonnage et des mots numériques de sortie désirés formant ensemble un code numérique binaire continu.

17. Dispositif selon la revendication 16, dans lequel la table de correspondance (TB) est couplée à la sortie des premiers moyens de conversion (CV2).

18. Dispositif selon l'une des revendications 9 à 17, réalisé sous forme intégrée.

## Claims

1. Logarithmic analogue/digital conversion method for an analogue input signal, comprising a logarithmic amplification with progressive compression (MAL) of the input signal (Vin) delivering a sequence of several secondary analogue signals (Vi), the trend of the values of at least some of the secondary signals as a function of the values of the analogue input signal including regions (Zi) corresponding to a linear trend of the secondary signals as a function of that of the input signal expressed in a logarithmic scale, a comparison (CMP) of at least some of the secondary signals of said sequence with a common reference signal (Vref) whose value lies within each of said regions, supplying a thermometric code information item (IDTC), and a generation of a first digital word (MN1) from the thermometric code information item.

2. Method according to Claim 1, in which the value of the reference signal (Vref) is chosen such that, when a secondary signal of rank i in said sequence takes the value equal to the value of the reference signal, the corresponding value of the secondary signal of rank i-1 lies within said region of this secondary signal of rank i-1.

3. Method according to Claim 1 or 2, in which the value of the reference signal (Vref) is a value lying in the vicinity of the bottom value of each region.

4. Method according to one of the preceding claims, in which the generation of the first digital word (MN1) comprises a conversion of the thermometric code information item (IDTC) into an intermediate code information item (Ii), a bit (Ii) of rank i of the intermediate code information item being obtained from the product of the complement of the bit of rank i and of the bit of rank i-1 or of its complement, of the thermometric code information item, and a conversion of the intermediate code information item into a binary code information item (B3-B7) forming said first digital word (MN1).

5. Method according to one of the preceding claims, also comprising a selection (MUX) of one of the secondary signals (Vi) of the sequence from the thermometric code information item (IDTC), a secondary analogue/digital conversion (ADC) of the selected secondary signal into a secondary thermometric code information item (T1-T11) and a conversion (CV10, CV20) of the secondary thermometric code information item into a second digital word (NM2), the first and second digital words respectively forming first and second portions of an output digital word (MNS), the second portion having a lower significance than the frit portion.

6. Method according to Claims 4 and 5, in which said selection of the secondary signal is made from the intermediate code information item (Ii).

7. Method according to one of Claims 5 to 6, in which all said regions (Zi) extend at least between a first common bottom limit value (VrefL) and a first common top limit value (VrefH) and the secondary analogue/digital conversion (ADC) of the selected secondary signal comprises a comparison of the secondary signal with reference thresholds evenly distributed between said first common bottom limit value and said first common top limit value.

8. Method according to Claim 7, in which the secondary analogue/digital conversion (ADC) of the selected secondary signal comprises a comparison of the secondary signal with reference thresholds evenly distributed between a second bottom limit value (Vref_low) lower than said first common bottom limit value (VrefL) and a second top limit value (Vref_high) higher than said first common top limit value (VrefH), and the method also comprises a calibration of said analogue/digital conversion with a calibration analogue signal (SGET) as input signal, this calibration signal following a monotonic time trend, and a generation of a mapping table (TB) between the first and second digital words (MN1, MN2) successively obtained during the analogue/digital conversion of the calibration signal and of the desired output digital words (MNS) together forming a continuous binary digital code (C0-C7).

9. Logarithmic analogue/digital conversion device, comprising input means (BE) configured to receive an analogue input signal (Vin) and processing means (MT) connected to the input means, **characterized in that** the processing means (MT) comprise logarithmic amplification means with progressive compression (MAL) connected to the input means and including a chain of several amplifier stages (AMP) configured each to deliver a secondary analogue signal (Vi), the trend of the values of at least some of the secondary analogue signals as a function of the values of the input analogue signal include regions (Zi) corresponding to a linear trend of the secondary signals as a function of that of the input signal expressed in a logarithmic scale, several comparison means (CMP) respectively having several first inputs (+) respectively connected to the outputs of at least some of the amplifier stages, several second inputs (-) configured each to receive a common reference signal (Vref) whose value lies within each of said regions, and several outputs configured to deliver a thermometric code information item (IDTC), first conversion means (CV1, CV2) connected to the outputs of the comparison means and configured to deliver a first digital word (MN1) from the thermometric code information item (IDTC).

10. Device according to Claim 9, in which the value of the reference signal (Vref) is chosen such that, when a secondary signal of rank i in said sequence takes the value equal to the value of the reference signal, the corresponding value of the secondary signal of rank i-1 lies within said region of this secondary signal of rank i-1.

11. Device according to Claim 9 or 10, in which the value of the reference signal (Vref) is a value that lies in the vicinity of the bottom value of each region.

12. Device according to one of Claims 9 to 11, in which the first conversion means comprise a first conversion block (CV1) configured to convert the thermometric code information item (IDTC) into an intermediate code information item (Ii), a bit of rank i of the intermediate code information item being obtained from the product of the complement of the bit of rank i and of the bit of rank i-1 or of its complement, of the thermometric code information item, and a second conversion block (CV2) configured to convert the intermediate code information item into a binary code information item forming said first digital word (MN1).

13. Device according to one of Claims 9 to 12, in which the processing means (MT) also comprise multiplexing means (MUX) having several inputs respectively connected to the outputs of at least some of the amplifier stages (AMP), an output and a command input (MEXC) connected to the outputs of the comparison means, secondary analogue/digital conversion means (ADC) connected to the output of the multiplexing means and configured to deliver a secondary thermometric code information item (T1-T11) and second conversion means (CV10, CV20) configured to convert the secondary thermometric code information item (T1-T11) into a second digital word (MN2) from the selected secondary signal delivered at the output of the multiplexing means, the first and second digital words respectively forming first and second portions of an output digital word (MNS), the second portion having a lower significance than the first portion.

14. Device according to Claims 12 and 13, in which said command input (MCEX) is coupled to the output of the first conversion block (CV1).

15. Device according to one of Claims 13 or 14, in which all said regions (Zi) extend at least between a first common bottom limit value and a first common top limit value and the secondary analogue/digital conversion means comprise a network of secondary comparators (CMPSi) configured to perform a comparison of the secondary signal with reference thresholds evenly distributed between said first common bottom limit value and said first common top limit value.

16. Device according to Claim 15, in which the secondary analogue/digital conversion means comprise a network of secondary comparators (CMPSi) configured to perform a comparison of the secondary signal with reference thresholds evenly distributed between a second bottom limit value lower than said first common bottom limit value and a second top limit value higher than said first common top limit value, and the device also comprises calibration means configured to perform a calibration of the processing means with an analogue calibration signal (SGET), as input signal, this calibration signal following a monotonic time trend, the calibration means including generation means configured to generate a mapping table (TB) between the first and second digital words successively obtained during the analogue/digital conversion of the calibration signal and of the desired output digital words together forming a continuous binary digital code.

17. Device according to Claim 16, in which the mapping table (TB) is coupled to the output of the first conversion means (CV2).

18. Device according to one of Claims 9 to 17, produced in integrated form.

## Patentansprüche

1. Verfahren zur logarithmischen Analog-Digital-Umwandlung eines analogen Eingangssignals, **dadurch gekennzeichnet, dass** es eine logarithmische Verstärkung mit progressiver Kompression (MAL) des analogen Eingangssignals (Vin), die eine Folge von mehreren analogen Sekundärsignalen (Vi) liefert, wobei die Entwicklung der Werte mindestens bestimmter der analogen Sekundärsignale abhängig von den Werten des analogen Eingangssignals Zonen (Zi) aufweist, die einer linearen Entwicklung der analogen Sekundärsignale abhängig von derjenigen des analogen Eingangssignals ausgedrückt in einer logarithmischen Skala entsprechen, einen Vergleich (CMP) zumindest bestimmter der analogen Sekundärsignale der Folge mit einem gemeinsamen Bezugssignal (Vref), dessen Wert sich in jeder der Zonen befindet, der eine thermometrische Codeinformation (IDTC) liefert, und eine Erarbeitung eines ersten digitalen Worts (MN1) ausgehend von der thermometrischen Codeinformation enthält.

2. Verfahren nach Anspruch 1, bei dem der Wert des Bezugssignals (Vref) so gewählt wird, dass, wenn ein Sekundärsignal des Rangs i in der Folge den Wert gleich dem Wert des Bezugssignals annimmt, der entsprechende Wert des Sekundärsignals des Rangs i-1 sich in der Zone dieses Sekundärsignals des Rangs i-1 befindet.

3. Verfahren nach Anspruch 1 oder 2, bei dem der Wert des Bezugssignals (Vref) ein Wert ist, der sich in der Nähe des unteren Werts jeder Zone befindet.

4. Verfahren nach einem der vorhergehenden Ansprüche, bei dem die Erarbeitung des ersten digitalen Worts (MN1) eine Umwandlung der thermometrischen Codeinformation (IDTC) in eine Zwischencodeinformation (Ii), wobei ein Bit (Ii) des Rangs i der Zwischencodeinformation ausgehend von dem Produkt des Komplements des Bits des Rangs i und des Bits des Rangs i-1 oder seines Komplements der thermometrischen Codeinformation erhalten wird, und eine Umwandlung der Zwischencodeinformation in eine Binärcodeinformation (B3-B7) enthält, die das erste digitale Wort (MN1) formt.

5. Verfahren nach einem der vorhergehenden Ansprüche, das außerdem eine Auswahl (MUX) eines der Sekundärsignale (Vi) der Folge ausgehend von der thermometrischen Codeinformation (IDTC), eine sekundäre Analog-Digital-Umwandlung (ADC) des ausgewählten Sekundärsignals in eine sekundäre thermometrische Codeinformation (T1-T11) und eine Umwandlung (CV10, CV20) der sekundären thermometrischen Codeinformation in ein zweites digitales Wort (MN2) enthält, wobei das erste und das zweite digitale Wort jeweils einen ersten bzw. zweiten Teil eines digitalen Ausgangsworts (MNS) formen, wobei der zweite Teil ein geringeres Gewicht hat als der erste Teil.

6. Verfahren nach den Ansprüchen 4 und 5, bei dem die Auswahl des Sekundärsignals ausgehend von der Zwischencodeinformation (Ii) durchgeführt wird.

7. Verfahren nach einem der Ansprüche 5 oder 6, bei dem alle Zonen (Zi) sich mindestens zwischen einem ersten gemeinsamen unteren Grenzwert (VrefL) und einem ersten gemeinsamen oberen Grenzwert (VrefH) erstrecken, und die sekundäre Analog-Digital-Umwandlung (ADC) des ausgewählten Sekundärsignals einen Vergleich des Sekundärsignals mit Bezugsschwellen enthält, die gleichmäßig zwischen dem ersten gemeinsamen unteren Grenzwert und dem ersten gemeinsamen oberen Grenzwert verteilt sind.

8. Verfahren nach Anspruch 7, bei dem die sekundäre Analog-Digital-Umwandlung (AOC) des ausgewählten Sekundärsignals einen Vergleich des Sekundärsignals mit Bezugsschwellen enthält, die gleichmäßig zwischen einem zweiten unteren Grenzwert (Vref_low) geringer als der erste gemeinsame untere Grenzwert (VrefL) und einem zweiten oberen Grenzwert (Vref_high) höher als der erste gemeinsame obere Grenzwert (VrefH) verteilt sind, und das Verfahren außerdem eine Kalibrierung der Analog-Digital-Umwandlung mit einem analogen Kalibrierungssignal (SGET) als Eingangssignal, wobei dieses Kalibrierungssignal einer monotonen zeitlichen Entwicklung folgt, und eine Erarbeitung einer Korrespondenztabelle (TB) zwischen den ersten und zweiten digitalen Wörtern (MN1, MN2), die nacheinander bei der Analog-Digital-Umwandlung des Kalibrierungssignals erhalten werden, und gewünschten digitalen Ausgangswörtern (MNS) enthält, die zusammen einen durchgehenden digitalen Binärcode (C0-C7) formen.

9. Vorrichtung zur logarithmischen Analog-Digital-Umwandlung, die Eingangseinrichtungen (BE), die konfiguriert sind, ein analoges Eingangssignal (Vin) zu empfangen, und mit den Eingangseinrichtungen verbundene Verarbeitungseinrichtungen (MT) aufweist, **dadurch gekennzeichnet, dass** die Verarbeitungseinrichtungen (MT) mit den Eingangseinrichtungen verbundene Einrichtungen zur logarithmischen Verstärkung mit progressiver Kompression (MAL) enthalten, die konfiguriert sind, eine Folge von analogen Sekundärsignalen zu liefern und
- eine Kette von mehreren Verstärkerstufen (AMP), die konfiguriert sind, je ein analoges Sekundärsignal (Vi) der Folge zu liefern, wobei die Entwicklung der Werte mindestens bestimmter der analogen Sekundärsignale abhängig von den Werten des analogen Eingangssignals Zonen (Zi) aufweist, die einer linearen Entwicklung der analogen Sekundärsignale abhängig von derjenigen des analogen Eingangssignals ausgedrückt in einer logarithmischen Skala entsprechen,
- mehrere Vergleichseinrichtungen (CMP), die je mehrere erste Eingänge (+), die je mit den Ausgängen mindestens bestimmter der Verstärkerstufen verbunden sind, mehrere zweite Eingänge (-), die konfiguriert sind, je ein gemeinsames Bezugssignal (Vref) zu empfangen, dessen Wert sich in jeder der Zonen befindet, und mehrere Ausgänge besitzen, die konfiguriert sind, eine thermometrische Codeinformation (IDTC) zu liefern,
- erste Umwandlungseinrichtungen (CV1, CV2), die mit den Ausgängen der Vergleichseinrichtungen verbunden und konfiguriert sind, ein erstes digitales Wort (MN1) ausgehend von der thermometrischen Codeinformation (IDTC) zu liefern,
aufweisen.

10. Vorrichtung nach Anspruch 9, bei der der Wert des Bezugssignals (Vref) so gewählt wird, dass, wenn ein Sekundärsignal des Rangs i in der Folge den Wert gleich dem Wert des Bezugssignal annimmt, der entsprechende Wert des Sekundärsignals des Rangs i-1 sich in der Zone dieses Sekundärsignals des Rangs i-1 befindet.

11. Vorrichtung nach Anspruch 9 oder 10, bei dem der Wert des Bezugssignals (Vref) ein Wert ist, der sich in der Nähe des unteren Werts jeder Zone befindet.

12. Vorrichtung nach einem der Ansprüche 9 bis 11, bei der die ersten Umwandlungseinrichtungen einen ersten Umwandlungsblock (CV1), der konfiguriert ist, die thermometrische Codeinformation (IDTC) in eine Zwischencodeinformation (Ii) umzuwandeln, wobei ein Bit des Rangs i der Zwischencodeinformation ausgehend von dem Produkt des Komplements des Bits des Rangs i und des Bits des Rangs i-1 oder seines Komplements der thermometrischen Codeinformation erhalten wird, und einen zweiten Umwandlungsblock (CV2) enthalten, der konfiguriert ist, die Zwischencodeinformation in eine Binärcodeinformation umzuwandeln, die das erste digitale Wort (MN1) formt.

13. Vorrichtung nach einem der Ansprüche 9 bis 12, bei der die Verarbeitungseinrichtungen (MT) außerdem Multiplexeinrichtungen (MUX), die mehrere Eingänge, welche je mit den Ausgängen mindestens bestimmter der Verstärkerstufen (AMP) verbunden sind, einen Ausgang und einen Steuereingang (MXEC) besitzen, der mit den Ausgängen der Vergleichseinrichtungen verbunden ist, sekundäre Analog-Digital-Wandlereinrichtungen (ADC), die mit dem Ausgang der Multiplexeinrichtungen verbunden und konfiguriert sind, eine sekundäre thermometrische Codeinformation (T1-T11) zu liefern, und zweite Umwandlungseinrichtungen (CV10, CV20) enthalten, die konfiguriert sind, die sekundäre thermometrische Codeinformation (T1-T11) in ein zweites digitales Wort (MN2) ausgehend von dem ausgewählten Sekundärsignal umzuwandeln, das am Ausgang der Multiplexeinrichtungen geliefert wird, wobei das erste und das zweite digitale Wort je erste und zweite Teile eines digitalen Ausgangsworts (MNS) formen, wobei der zweite Teil ein geringeres Gewicht hat als der erste Teil.

14. Vorrichtung nach den Ansprüchen 12 und 13, bei der der Steuereingang (MXEC) mit dem Ausgang des ersten Umwandlungsblocks (CV1) gekoppelt ist.

15. Vorrichtung nach einem der Ansprüche 13 oder 14, bei der alle Zonen (Zi) sich mindestens zwischen einem ersten gemeinsamen unteren Grenzwert und einem ersten gemeinsamen oberen Grenzwert erstrecken, und die sekundären Analog-Digital-Wandlereinrichtungen ein Netz von sekundären Komparatoren (CMPSi) enthalten, die konfiguriert sind, einen Vergleich des Sekundärsignals mit Bezugsschwellen durchzuführen, die gleichmäßig zwischen dem ersten gemeinsamen unteren Grenzwert und dem ersten gemeinsamen oberen Grenzwert verteilt sind.

16. Vorrichtung nach Anspruch 15, bei der die sekundären Analog-Digital-Wandlereinrichtungen ein Netz von sekundären Komparatoren (CMPSi) enthalten, die konfiguriert sind, einen Vergleich des Sekundärsignals mit Bezugsschwellen durchzuführen, die gleichmäßig zwischen einem zweiten unteren Grenzwert geringer als der erste gemeinsame untere Grenzwert und einem zweiten oberen Grenzwert höher als der erste gemeinsame obere Grenzwert verteilt sind, und die Vorrichtung außerdem Kalibrierungseinrichtungen enthält, die konfiguriert sind, eine Kalibrierung der Verarbeitungseinrichtungen mit einem analogen Kalibrierungssignal (SGET) als Eingangssignal durchzuführen, wobei dieses Kalibrierungssignal einer monotonen zeitlichen Entwicklung folgt, wobei die Kalibrierungseinrichtungen Erarbeitungseinrichtungen aufweisen, die konfiguriert sind, eine Korrespondenztabelle (TB) zwischen den ersten und zweiten digitalen Wörtern, die nacheinander bei der Analog-Digital-Umwandlung des Kalibrierungssignals erhalten werden, und gewünschten digitalen Ausgangswörtern zu erarbeiten, die zusammen einen durchgehenden digitalen Binärcode formen.

17. Vorrichtung nach Anspruch 16, bei der die Korrespondenztabelle (TB) mit dem Ausgang der ersten Wandlereinrichtungen (CV2) gekoppelt ist.

18. Vorrichtung nach einem der Ansprüche 9 bis 17, die in integrierter Form hergestellt ist.
